# EUROPEAN PATENT APPLICATION

(11) **EP 4 827 269 A2**
(43) Date of publication of application: **21.10.2026**
(21) Application number: 26201620.7
(22) Date of filing: 29.09.2017
(51) Int. Cl.: H10D 30/01, H10D 30/60, H10D 62/10, H10D 62/17, H10D 12/00

(54) **POWER SEMICONDUCTOR DEVICES HAVING GATE TRENCHES WITH IMPLANTED SIDEWALLS AND RELATED METHODS**

(30) Priority: 08.12.2016 US 201615372516
(62) Document number(s) of the earlier application(s) in accordance with Art. 76 EPC: 17781344.1 / 3 552 230
(71) Applicant: Wolfspeed, Inc., Durham, NC 27703 (US)
(72) Inventor: LICHTENWALNER, Daniel J., Raleigh, NC 27603 (US); VAN BRUNT, Edward R., Raleigh, NC 27606 (US); HULL, Brett, Raleigh, NC 27614 (US); SUVOROV, Alexander V., Durham, NC 27713 (US); CAPELL, Craig, Hillsborough, NC 27278 (US)
(74) Representative: Boult Wade Tennant LLP

(57) **Abstract**

Semiconductor devices include a semiconductor layer structure having a wide band-gap semiconductor drift region having a first conductivity type. A gate trench is provided in an upper portion of the semiconductor layer structure, the gate trench having first and second opposed sidewalls that extend in a first direction in the upper portion of the semiconductor layer structure. These devices further include a deep shielding pattern having a second conductivity type that is opposite the first conductivity type in the semiconductor layer structure underneath a bottom surface of the gate trench, and a deep shielding connection pattern that has the second conductivity type in the first sidewall of the gate trench. The devices include a semiconductor channel region that has the first conductivity type in the second sidewall of the gate trench.

## Description

### STATEMENT OF U.S. GOVERNMENT INTEREST

This invention was made with Government support under Cooperative Agreement No. W911NF-12-2-0064 funded by the Army Research Laboratory. The Government has certain rights in the invention.

### FIELD OF THE INVENTION

The present invention relates to power semiconductor devices and, more particularly, to power semiconductor devices having gate trenches and to methods of fabricating such devices.

### BACKGROUND

Power semiconductor devices are used to carry large currents and support high voltages. A wide variety of power semiconductor devices are known in the art including, for example, power Metal Oxide Semiconductor Field Effect Transistors ("MOSFET"), bipolar junction transistors ("BJTs"), Insulated Gate Bipolar Transistors ("IGBT"), Junction Barrier Schottky diodes, Gate Turn-Off Transistors ("GTO"), MOS-controlled thyristors and various other devices. These power semiconductor devices are generally fabricated from wide band-gap semiconductor materials, such as silicon carbide ("SiC") or gallium nitride ("GaN") based semiconductor materials. Herein, a wide band-gap semiconductor material refers to a semiconductor material having a band-gap greater than 1.40 eV.

Power semiconductor devices can have a lateral structure or a vertical structure. In a device having a lateral structure, the terminals of the device (e.g., the drain, gate and source terminals for a power MOSFET device) are on the same major surface (i.e., top or bottom) of a semiconductor layer structure. In contrast, in a device having a vertical structure, at least one terminal is provided on each major surface of the semiconductor layer structure (e.g., in a vertical MOSFET device, the source may be on the top surface of the semiconductor layer structure and the drain may be on the bottom surface of the semiconductor layer structure). The semiconductor layer structure may or may not include an underlying substrate. Herein, the term "semiconductor layer structure" refers to a structure that includes one or more semiconductor layers, such as semiconductor substrates and/or semiconductor epitaxial layers.

A conventional power semiconductor device typically has a semiconductor substrate, such as a silicon carbide substrate having a first conductivity type (e.g., an n-type substrate), on which an epitaxial layer structure having the first conductivity type (e.g., n-type) is formed. A portion of this epitaxial layer structure (which may comprise one or more separate layers) functions as a drift region of the power semiconductor device. The device typically includes an "active region," which includes one or more power semiconductor devices that have a junction such as a p-n junction. The active region may be formed on and/or in the drift region. The active region acts as a main junction for blocking voltage in the reverse bias direction and providing current flow in the forward bias direction. The power semiconductor device may also have an edge termination in a termination region that is adjacent the active region. One or more power semiconductor devices may be formed on the substrate, and each power semiconductor device will typically have its own edge termination. After the substrate is fully processed, the resultant structure may be diced to separate the individual edge-terminated power semiconductor devices. The power semiconductor devices may have a unit cell structure in which the active region of each power semiconductor device includes a plurality of individual "unit cell" devices that are disposed in parallel to each other and that together function as a single power semiconductor device.

Power semiconductor devices are designed to block (in the forward or reverse blocking state) or pass (in the forward operating state) large voltages and/or currents. For example, in the blocking state, a power semiconductor device may be designed to sustain hundreds or thousands of volts of electric potential. However, as the applied voltage approaches or passes the voltage level that the device is designed to block, non-trivial levels of current may begin to flow through the power semiconductor device. Such current, which is typically referred to as "leakage current," may be highly undesirable. Leakage current may begin to flow if the voltage is increased beyond the design voltage blocking capability of the device, which may be a function of, among other things, the doping and thickness of the drift region. Leakage currents may also arise for other reasons, such as failure of the edge termination and/or the primary junction of the device. If the voltage applied to the device is increased past the breakdown voltage to a critical level, the increasing electric field may result in an uncontrollable and undesirable runaway generation of charge carriers within the semiconductor device, leading to a condition known as avalanche breakdown.

A power semiconductor device may also begin to allow non-trivial amounts of leakage current to flow at a voltage level that is lower than the designed breakdown voltage of the device. In particular, leakage current may begin to flow at the edges of the active region, where high electric fields may occur due to electric field crowding effects. In order to reduce this electric field crowding (and the resulting increased leakage currents), the above-mentioned edge terminations may be provided that surround part or all of the active region of a power semiconductor device. These edge terminations may spread the electric field out over a greater area, thereby reducing the electric field crowding.

Vertical power semiconductor devices that include a MOSFET transistor can have a standard gate electrode design in which the gate electrode of the transistor is formed on top of the semiconductor layer structure or, alternatively, may have the gate electrode buried in a trench within the semiconductor layer structure. MOSFETs having buried gate electrodes are typically referred to as gate trench MOSFETs. With the standard gate electrode design, the channel region of each unit cell transistor is horizontally disposed underneath the gate electrode. In contrast, in the gate trench MOSFET design, the channel is vertically disposed. Gate trench MOSFETs may provide enhanced performance, but typically require a more complicated manufacturing process.

### SUMMARY

Pursuant to embodiments of the present invention, semiconductor devices are provided that include a semiconductor layer structure comprising a drift region that includes a wide band-gap semiconductor material, the drift region having a first conductivity type. A gate trench is provided in an upper portion of the semiconductor layer structure, the gate trench having first and second opposed sidewalls that extend in a first direction in the upper portion of the semiconductor layer structure. In some embodiments where the wide band-gap semiconductor material is silicon carbide, the sidewalls of the gate trench may be oriented along a crystallographic plane of the silicon carbide semiconductor layer structure, such as the A-face {11-20} or M-face {1-100} family of planes that are oriented 90 degrees to the silicon-face (0001) plane of the silicon carbide, the silicon-face being a few degrees from the typical silicon carbide wafer surface plane. Alternately, the gate trench may be formed at a small angle from these family of planes, or near other planes such as the R-plane {0-33-8}family of planes. These devices further include a deep shielding pattern having a second conductivity type that is opposite the first conductivity type in the semiconductor layer structure underneath a bottom surface of the gate trench, and a deep shielding connection pattern that has the second conductivity type in the first sidewall of the gate trench. Finally, the devices include a semiconductor channel region that has the first conductivity type in the second sidewall of the gate trench.

In some embodiments, the semiconductor channel region may be in a portion of the second sidewall that is directly opposite a portion of the first sidewall that includes a portion of the deep shielding connection pattern.

In some embodiments, the semiconductor layer structure may further include a well region having the second conductivity type, and the deep shielding connection pattern may electrically connect the deep shielding pattern to the well region.

In some embodiments, the gate trench may be in an active region of the semiconductor device, and the semiconductor device may further include a termination region that surrounds the active region. The termination region may include a plurality of termination trenches in the upper portion of the semiconductor layer structure.

In some embodiments, the semiconductor device may further include a plurality of termination structures having the second conductivity type that are provided beneath the respective termination trenches.

In some embodiments, the termination structures may also extend into an inner sidewall but not an outer sidewall of a first portion of the respective termination trenches and may extend into the outer sidewall but not the inner sidewall of a second portion of the respective termination trenches.

In some embodiments, a bottom of the deep shielding pattern may be at approximately the same depth in the semiconductor layer structure as a bottom of each termination structure. In some embodiments, the termination structures may be guard rings.

In some embodiments, the first sidewall of the gate trench may be angled at an angle of less than eighty degrees with respect to the upper portion of the semiconductor layer structure.

In some embodiments, the deep shielding pattern may comprise a plurality of spaced apart deep shielding regions underneath the gate trench and the deep shielding connection pattern may comprise a plurality of spaced apart deep shielding connection regions in the first sidewall of the gate trench. The semiconductor channel region may be in a portion of the second sidewall that is opposite a portion of the first sidewall that is between first and second of the deep shielding connection regions.

In some embodiments, the deep shielding pattern may be a continuous deep shielding region that extends underneath the gate trench and the deep shielding connection pattern may be a continuous deep shielding connection region in the first sidewall of the gate trench.

In some embodiments, the wide band-gap semiconductor may be silicon carbide.

Pursuant to further embodiments of the present invention, semiconductor devices are provided that include a semiconductor layer structure that has an active and a termination region. The semiconductor layer structure includes a drift region that comprises a wide band-gap semiconductor material doped with dopants having a first conductivity type. A plurality of gate trenches are provided in the active region that are formed in an upper portion of the semiconductor layer structure, the gate trenches extending in a first direction and spaced apart from each other in a second direction that is perpendicular to the first direction. The semiconductor device further includes a plurality of deep shielding patterns doped with dopants having a second conductivity type that is opposite the first conductivity type, the deep shielding patterns located in the semiconductor layer structure underneath the respective gate trenches. The device also includes a plurality of termination trenches in the termination region that are formed in the upper portion of the semiconductor layer structure. Finally, the semiconductor device includes a plurality of termination structures doped with dopants having the second conductivity type, the termination structures located in the semiconductor layer structure underneath the respective termination trenches.

In some embodiments, each termination structure may also extend into at least one sidewall of the respective termination trenches.

In some embodiments, the semiconductor device may further include a plurality of deep shielding connection patterns that have the second conductivity type in first sidewalls of the respective gate trenches. Each deep shielding connection pattern may electrically connect a respective one of the deep shielding patterns to a common source contact.

In some embodiments, the semiconductor device may further include a plurality of semiconductor channel regions that have the first conductivity type in the second sidewalls of the respective gate trenches.

In some embodiments, each semiconductor channel region may be directly opposite a portion of the first sidewall that includes a portion of a respective one of the deep shielding connection patterns.

In some embodiments, the termination structures may extend into an inner sidewall but not an outer sidewall of a first portion of the respective termination trenches and into the outer sidewall but not the inner sidewall of a second portion of the respective termination trenches.

In some embodiments, a bottom of each deep shielding pattern may be at approximately the same depth in the semiconductor layer structure as a bottom of each termination structure.

In some embodiments, the wide band-gap semiconductor may be silicon carbide.

Pursuant to still further embodiments of the present invention, methods of forming a semiconductor device are provided in which a wide band-gap semiconductor layer structure is formed on a substrate, the semiconductor layer structure including a drift region that has a first conductivity type. A plurality of gate trenches are formed in an upper portion of the semiconductor layer structure, the gate trenches extending in a first direction and spaced apart from each other in a second direction that is perpendicular to the first direction, each gate trench having a bottom surface, a first sidewall that extends in the first direction and a second sidewall that extends in the first direction. Dopants having the second conductivity type that is opposite the first conductivity type are implanted into the bottom surfaces and the first sidewalls of the gate trenches.

In some embodiments, the dopants having the second conductivity type may be implanted into the first sidewalls of the gate trenches using an angled ion implant.

In some embodiments, the semiconductor device may be a vertical semiconductor device having a first source/drain contact on a first major surface of the semiconductor layer structure and a second source/drain contact on a second major surface of the semiconductor layer structure that is opposite the first major surface.

In some embodiments, the semiconductor layer structure may include a plurality of well regions having the second conductivity type between the gate trenches.

In some embodiments, the second conductivity dopants implanted into the bottom surfaces of the gate trenches may form a plurality of deep shielding patterns underneath the respective gate trenches, and the second conductivity dopants implanted into the first sidewall of the gate trenches may form a plurality of deep shielding connection patterns that electrically connect the deep shielding regions to the respective well regions.

In some embodiments, channel regions may be formed in the respective second sidewalls of the gate trenches.

In some embodiments, each channel region may be directly opposite a portion of a respective one of the deep shielding connection patterns.

In some embodiments, the well regions may be in the semiconductor layer structure, and the semiconductor layer structure may be formed in a single epitaxial growth process.

In some embodiments, the first sidewall of the gate trench may be angled at an angle of less than eighty degrees with respect to an upper portion of the semiconductor layer structure.

In some embodiments, a termination structure may be formed in a termination region of the semiconductor device. The termination structure may be formed by ion implantation simultaneously with the deep shielding patterns and the deep shielding connection patterns.

In some embodiments, forming the termination structure may comprise forming a plurality of termination trenches in the termination region; and implanting a bottom surface and a first sidewall of each termination trench with dopants having the second conductivity type.

In some embodiments, the bottom surfaces and first sidewalls of the termination trenches may be formed via an angled ion implant.

In some embodiments, a second angled ion implant may be performed to implant second conductivity type dopants into the second sidewalls of the gate trenches.

In some embodiments, each deep shielding pattern may comprise a plurality of spaced apart deep shielding regions underneath each gate trench.
The following numbered clauses show further illustrative examples only:
1. A semiconductor device, comprising:
   a semiconductor layer structure comprising a drift region that includes a wide band-gap semiconductor material, the drift region having a first conductivity type;
   a gate trench in an upper portion of the semiconductor layer structure, the gate trench having first and second opposed sidewalls that extend in a first direction in the upper portion of the semiconductor layer structure;
   a deep shielding pattern having a second conductivity type that is opposite the first conductivity type in the semiconductor layer structure underneath a bottom surface of the gate trench;
   a deep shielding connection pattern that has the second conductivity type in the first sidewall of the gate trench; and
   a semiconductor channel region that has the first conductivity type in the second sidewall of the gate trench.
2. The semiconductor device of clause 1, wherein the semiconductor channel region is in a portion of the second sidewall that is directly opposite a portion of the first sidewall that includes a portion of the deep shielding connection pattern.
3. The semiconductor device of clause 2, wherein the semiconductor layer structure further comprises a well region having the second conductivity type, wherein the deep shielding connection pattern electrically connects the deep shielding pattern to the well region.
4. The semiconductor device of any of clauses 1-3, wherein the gate trench is in an active region of the semiconductor device, the semiconductor device further comprising a termination region that surrounds the active region, the termination region including a plurality of termination trenches in the upper portion of the semiconductor layer structure.
5. The semiconductor device of clause 4, further comprising a plurality of termination structures having the second conductivity type that are provided beneath the respective termination trenches.
6. The semiconductor device of any of clauses 4 or 5, wherein the termination structures also extend into an inner sidewall but not an outer sidewall of a first portion of the respective termination trenches and into the outer sidewall but not the inner sidewall of a second portion of the respective termination trenches.
7. The semiconductor device of any of clauses 4-6, wherein a bottom of the deep shielding pattern is at approximately a same depth in the semiconductor layer structure as a bottom of each termination structure.
8. The semiconductor device of any of clauses 4-7, wherein the termination structures comprise guard rings.
9. The semiconductor device of any of clauses 1-8, further comprising:
   a gate insulation layer in the gate trench that at least partially covers the bottom surface and the first and second sidewalls of the gate trench;
   a gate electrode in the gate trench on the gate insulation layer;
   a first source/drain contact on the upper portion of the semiconductor layer structure; and
   a second source/drain contact on a lower surface of the semiconductor layer structure.
10. The semiconductor device of any of clauses 1-9, further comprising:
   an additional plurality of gate trenches in the upper portion of the semiconductor layer structure, each of the additional plurality of gate trenches having respective first and second opposed sidewalls that extend in the first direction;
   an additional plurality of deep shielding patterns having the second conductivity type in the semiconductor layer structure underneath bottom surfaces of the respective additional plurality of gate trenches;
   an additional plurality of deep shielding connection patterns that have the second conductivity type in first sidewalls of the respective additional plurality of gate trenches; and
   an additional plurality of semiconductor channel regions that have the first conductivity type in the second sidewalls of the respective additional plurality of gate trenches.
11. The semiconductor device of any of clauses 1-10, wherein the first sidewall of the gate trench is angled at an angle of less than eighty degrees with respect to the upper portion of the semiconductor layer structure.
12. The semiconductor device of any of clauses 1-11, wherein the deep shielding pattern comprises a plurality of spaced apart deep shielding regions underneath the gate trench and the deep shielding connection pattern comprises a plurality of spaced apart deep shielding connection regions in the first sidewall of the gate trench, wherein the semiconductor channel region is in a portion of the second sidewall that is opposite a portion of the first sidewall that is between first and second of the deep shielding connection regions.
13. The semiconductor device of any of clauses 1-12, wherein the deep shielding pattern comprises a continuous deep shielding region that extends underneath the gate trench and the deep shielding connection pattern comprises a continuous deep shielding connection region in the first sidewall of the gate trench.
14. The semiconductor device of any of clauses 1-13, wherein the wide band-gap semiconductor comprises silicon carbide.
15. A semiconductor device, comprising:
   a semiconductor layer structure that has an active region and a termination region, the semiconductor layer structure comprising a drift region that includes a wide band-gap semiconductor material having a first conductivity type;
   a plurality of gate trenches in the active region that are formed in an upper portion of the semiconductor layer structure, the gate trenches extending in a first direction and spaced apart from each other in a second direction that is perpendicular to the first direction;
   a plurality of deep shielding patterns doped with dopants having a second conductivity type that is opposite the first conductivity type, the deep shielding patterns located in the semiconductor layer structure underneath the respective gate trenches;
   a plurality of termination trenches in the termination region that are formed in the upper portion of the semiconductor layer structure;
   a plurality of termination structures doped with dopants having the second conductivity type, the termination structures located in the semiconductor layer structure underneath the respective termination trenches.
16. The semiconductor device of clause 15, wherein each termination structure also extends into at least one sidewall of the respective termination trenches.
17. The semiconductor device of clauses 15 or 16, further comprising a plurality of deep shielding connection patterns that have the second conductivity type in first sidewalls of the respective gate trenches, each deep shielding connection pattern electrically connecting a respective one of the deep shielding patterns to a common source contact.
18. The semiconductor device of any of clauses 15-17, further comprising a plurality of semiconductor channel regions that have the first conductivity type in the second sidewalls of the respective gate trenches.
19. The semiconductor device of any of clauses 15-18, wherein each semiconductor channel region is directly opposite a portion of the first sidewall that includes a portion of a respective one of the deep shielding connection patterns.
20. The semiconductor device of any of clauses 15-19, wherein the termination structures also extend into an inner sidewall but not an outer sidewall of a first portion of the respective termination trenches and into the outer sidewall but not the inner sidewall of a second portion of the respective termination trenches.
21. The semiconductor device of any of clauses 15-20, wherein a bottom of each deep shielding pattern is at approximately a same depth in the semiconductor layer structure as a bottom of each termination structure.
22. The semiconductor device of any of clauses 15-21, wherein the wide band-gap semiconductor comprises silicon carbide.
23. A method of forming a semiconductor device, the method comprising:
   forming a wide band-gap semiconductor layer structure on a substrate, the semiconductor layer structure including a drift region that has a first conductivity type;
   forming a plurality of gate trenches in an upper portion of the semiconductor layer structure, the gate trenches extending in a first direction and spaced apart from each other in a second direction that is perpendicular to the first direction, each gate trench having a bottom surface, a first sidewall that extends in the first direction and a second sidewall that extends in the first direction; and
   implanting dopants having the second conductivity type that is opposite the first conductivity type into the bottom surfaces and the first sidewalls of the gate trenches.
24. The method of clause 23, wherein the dopants having the second conductivity type are implanted into the first sidewalls of the gate trenches using an angled ion implant.
25. The method of clauses 23 or 24, wherein the semiconductor device is a vertical semiconductor device having a first source/drain contact on a first major surface of the semiconductor layer structure and a second source/drain contact on a second major surface of the semiconductor layer structure that is opposite the first major surface.
26. The method of any of clauses 23-25, wherein the semiconductor layer structure includes a plurality of well regions having the second conductivity type between the gate trenches.
27. The method of any of clauses 23-26, wherein the second conductivity dopants implanted into the bottom surfaces of the gate trenches form a plurality of deep shielding patterns underneath the respective gate trenches, and the second conductivity dopants implanted into the first sidewall of the gate trenches form a plurality of deep shielding connection patterns that electrically connect the deep shielding regions to the respective well regions.
28. The method of any of clauses 23-27, wherein channel regions are formed in the respective second sidewalls of the gate trenches.
29. The method of any of clauses 23-28, wherein each channel region is directly opposite a portion of a respective one of the deep shielding connection patterns.
30. The method of any of clauses 23-29, wherein the well regions are in the semiconductor layer structure, and wherein the semiconductor layer structure is formed in a single epitaxial growth process.
31. The method of any of clauses 23-30, wherein the first sidewall of the gate trench is angled at an angle of less than eighty degrees with respect to an upper portion of the semiconductor layer structure.
32. The method of any of clauses 23-31, further comprising forming a termination structure in a termination region of the semiconductor device, wherein the termination structure is formed by ion implantation simultaneously with the deep shielding patterns and the deep shielding connection patterns.
33. The method of any of clauses 23-32, wherein forming the termination structure comprises:
   forming a plurality of termination trenches in the termination region; and
   implanting a bottom surface and a first sidewall of each termination trench with dopants having the second conductivity type.
34. The method of any of clauses 23-33, wherein the bottom surfaces and first sidewalls of the termination trenches are formed via an angled ion implant.
35. The method of any of clauses 23-34, further comprising forming a second angled ion implant to implant second conductivity type dopants into the second sidewalls of the gate trenches.
36. The method of any of clauses 23-35, wherein each deep shielding pattern comprises a plurality of spaced apart deep shielding regions underneath each gate trench.
37. The method of any of clauses 23-36, wherein the wide band-gap semiconductor comprises silicon carbide.
38. The method of any of clauses 23-37, wherein at least a portion of the angled ion implant is at an implantation angle of between two and fifteen degrees from a vertical implant.
39. The method of any of clauses 23-38, wherein the angled ion implant implants the dopants at more than one angle and at more than one implantation energy.

### BRIEF DESCRIPTION OF THE DRAWINGS

**FIG. 1** is a schematic cross-sectional diagram of a first convention gate trench power MOSFET.
**FIG. 2** is a schematic cross-sectional diagram of a second conventional gate trench power MOSFET.
**FIG. 3** is a schematic cross-sectional diagram of a third conventional gate trench power MOSFET.
**FIG. 4A** is a schematic plan view of a portion of a gate trench power MOSFET according to embodiments of the present invention.
**FIG. 4B** is a schematic cross-sectional view of the gate trench power MOSFET of **FIG. 4A** taken along line **4B-4B** of **FIG. 4A****.**
**FIG. 5** is a schematic cross-sectional diagram of a gate trench power MOSFET according to further embodiments of the present invention that includes angled gate trenches.
**FIG. 6A** is a simplified circuit diagram of a p-channel silicon carbide power insulated gate bipolar transistor ("IGBT") according to embodiments of the present invention.
**FIG. 6B** is a schematic cross-sectional diagram of a unit cell of the IGBT of **FIG. 6A****.**
**FIG. 7A** is a schematic cross-sectional diagram of a gate trench power MOSFET according to still further embodiments of the present invention that illustrates an edge termination that is formed in a termination region of the device.
**FIG. 7B** is a schematic plan view of the gate trench power MOSFET of **FIG. 7A** that illustrates the edge termination of the device in further detail.
**FIG. 8** is a plan view of a modified version of the power MOSFET of **FIGS. 4A-4B****.**
**FIGS. 9A-9F** are schematic cross-sectional diagrams that illustrate a method of fabricating the gate trench power MOSFET of **FIGS. 4A-4B****.**
**FIG. 10A** is a schematic plan view of a portion of a gate trench power MOSFET according to further embodiments of the present invention.
**FIG. 10B** is a schematic cross-sectional view of the gate trench power MOSFET of **FIG. 10A** taken along line **10B-10B** of **FIG. 10A****.**
**FIG. 10C** is a schematic cross-sectional view of the gate trench power MOSFET of **FIG. 10A** taken along line **10C-10C** of **FIG. 10A****.**
**FIG. 10D** is a schematic cross-sectional view of the gate trench power MOSFET of **FIG. 10A** taken along line **10D-10D** of **FIG. 10A****.**
**FIG. 11** is a cross-sectional view taken along line **10C-10C** of **FIG. 10A** that illustrates the design of a modified version of the power MOSFET of **FIGS. 10A-10D****.**
**FIG. 12** is a flow chart that illustrates a method of fabricating gate trench power semiconductor devices according to embodiments of the present invention.
**FIG. 13** is a schematic cross-sectional diagram of a gate trench power MOSFET according to further embodiments of the present invention that includes a guard ring edge termination formed using a mesa etch.
**FIG. 14** is a schematic cross-sectional diagram of a gate trench power MOSFET according to yet further embodiments of the present invention that includes a junction termination extension edge termination formed using a mesa etch.
**FIG. 15** is a plan view of a gate trench power MOSFET according to additional embodiments of the present invention that includes a guard ring edge termination.

### DETAILED DESCRIPTION

One challenge in fabricating wide band-gap semiconductor power devices is that it may be more difficult to dope wide band-gap semiconductor materials with impurities to impart n-type or p-type conductivity in certain regions of the power semiconductor devices. This is particularly true in vertical power devices that include gate trenches, as it is often necessary to form regions having a first conductivity type within layers having a second conductivity type at deep levels within the device such as, for example, 1-5 microns or more from the upper surface of the device. This may pose challenges when the power semiconductor device is fabricated in silicon carbide or other wide band-gap semiconductor materials.

The primary methods for doping a semiconductor material with n-type and/or p-type dopants are (1) doping the semiconductor material during the growth thereof, (2) diffusing the dopants into the semiconductor material and (3) using ion implantation to selectively implant the dopants in the semiconductor material. When silicon carbide is doped during epitaxial growth, the dopants tend to unevenly accumulate, and hence the dopant concentration may vary by, for example, +/-15%, which can negatively affect device operation and/or reliability. Additionally, doping by diffusion is not an option in silicon carbide, gallium nitride and various wide band-gap semiconductor devices since n-type and p-type dopants tend to not diffuse well (or at all) in there materials, even at high temperatures.

Because of the above limitations, ion implantation is often used to dope wide band-gap semiconductor materials, such as silicon carbide. However, in gate-trench vertical power devices, it may be desirable to form deep shielding patterns underneath the well regions and/or gate electrodes of the device, and these deep shielding patterns often extend into the device to depths of 1-3 microns or more. The depth at which the ions are implanted is directly related to the energy of the implant, i.e., ions implanted into a semiconductor layer at higher energies tend to go deeper into the layer. Thus, forming deep shielding patterns via ion implantation requires high energy implants. When dopant ions are implanted into a semiconductor layer, the ions damage the crystal lattice of the semiconductor layer, and this damage typically can only be partly repaired by thermal annealing. Moreover, the amount of lattice damage is also directly related to the implant energy, with higher energy implants tending to cause more lattice damage than lower energy implants, and the uniformity of the ion implant also tends to decrease with increasing implant depth. Thus, to form implanted regions that have good doping uniformity by depth and/or acceptable levels of lattice damage, it may be necessary to perform a multiple successive epitaxial growth/ion implantation steps to form a deep implant. This may significantly increase the complexity and cost of the manufacturing process and may not be a commercially viable option in many instances.

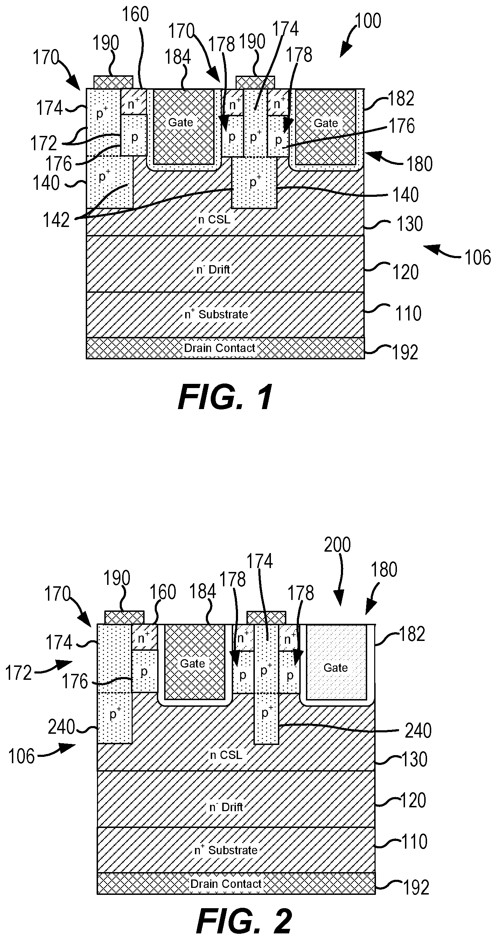

Various approaches have been used conventionally to form deep shielding patterns in gate trench vertical power semiconductor devices. **FIGS. 1-3** schematically illustrate several different approaches.

**FIG. 1** is a schematic cross-sectional diagram of a first wide band-gap power MOSFET **100.** As shown in **FIG. 1****,** the power MOSFET **100** includes a heavily-doped (n⁺) n-type silicon carbide substrate **110.** A lightly-doped (n⁻) silicon carbide drift region **120** is provided on the substrate **110.** The upper portion of the n-type silicon carbide drift region **120** may be an n-type silicon carbide current spreading layer ("CSL") **130.** The n-type silicon carbide current spreading layer **130** may be grown in the same processing step as the remainder of the n-type silicon carbide drift region **120** and may be considered to be part of the silicon carbide drift region **120.** The n-type silicon carbide current spreading layer **130** may be a moderately-doped layer that has a doping concentration that exceeds the doping concentration of the remainder of the n-type silicon carbide drift region **120,** which may be more lightly-doped n⁻ silicon carbide.

Spaced apart heavily-doped (p⁺) p-type silicon carbide deep shielding patterns **140** are formed in the upper surface of the n-type current spreading layer **130** by ion implantation. A moderately-doped p-type silicon carbide layer **170** is then formed by epitaxial growth on the upper surface of the n-type current spreading layer **130** and on top of the p⁺ silicon carbide deep shielding patterns **140.** This moderately-doped p-type silicon carbide layer **170** acts as the p-wells **172** for the device **100.** Heavily-doped p⁺ silicon carbide regions **174** are formed in the p-wells **172** via ion implantation that are electrically connected to the deep shielding patterns **140** thereunder. The p-wells **172** also include moderately-doped p-type regions **176** that are adjacent the heavily-doped regions **174.** The p-type regions **174, 176** together form a p-well **172.** The transistor channels may be formed in the moderately-doped regions **176** of the p-wells **172,** as will be discussed below. The substrate **110,** drift region **120** (including current spreading layer **130**) and the moderately doped p-type layer **170,** along with the various regions/patterns formed therein, comprises a semiconductor layer structure **106** of the MOSFET **100.**

Gate trenches **180** are formed in the semiconductor layer structure **106.** The gate trenches **180** extend through the moderately-doped p-type layer **170** to define the p-wells **172.** A gate insulating layer **182** is formed on the bottom surface and sidewalls of each gate trench **180.** A gate electrode **184** is formed on each gate insulating layer **182** to fill the respective gate trenches **180.** Vertical channel regions **178** are provided in the p-wells **172** adjacent the gate insulating layer **182.**

Heavily-doped n⁺ silicon carbide source regions **160** are formed in upper portions of the p-wells **172** via ion implantation. Source contacts **190** are formed on the heavily-doped n-type source regions **160** and on the p-wells **172.** A drain contact **192** is formed on the lower surface of the substrate **110.** A gate contact (not shown) may be formed on each gate electrode **184.**

The heavily-doped p⁺ silicon carbide deep shielding patterns **140** include lower lateral extensions **142** that extend under the moderately-doped portions **176** of the p-wells **172.** These lateral extensions **142** may help block the electric field during reverse blocking operation in order to protect the corners of the gate insulating layer **182** from high electric fields. If the gate insulating layer **182,** which is typically implemented as a silicon oxide layer, is subjected to overly high electric fields, it can degrade over time and eventually fail to insulate the gate electrode **184** from the underlying current spreading layer **130,** which can result in device failure.

The design of the above-described power MOSFET **100** has several potential short-comings. First, the p-wells **172** are typically doped during epitaxial growth so that the regions **174, 176** thereof may have different doping concentrations without the need for two separate p-type dopant ion implantation steps to form these regions. As discussed above, it may be difficult to maintain a consistent doping concentration when doping during epitaxial growth in wide band-gap semiconductor materials, and variations in the doping levels may result in degraded device performance and/or an increase in the likelihood of device failure. Second, an additional ion implantation step is required to form the heavily-doped p⁺ regions **174** in the p-wells **172,** which increases the manufacturing time and cost. Third, precise alignment is required during the formation of the gate trenches **180** and various other processing steps that occur after formation of the deep shielding patterns **140** to ensure that the gate trenches **180** and the heavily-doped p⁺ portions **174** of the p-wells **172** are properly aligned with respect to the deep shielding patterns **140** thereunder. Such precise alignment may be difficult to consistently achieve in a production setting, and when not achieved, may result in device failure.

**FIG. 2** is a schematic cross-sectional diagram of a second conventional wide band-gap power MOSFET **200.** As can be seen by comparing **FIGS. 1** and **2****,** the power MOSFETs **100** and **200** are similar in design. Consequently, same or similar components of the two power MOSFETS **100, 200** have been labeled with the same reference numerals, and descriptions of these same/similar components will generally be omitted with respect to power MOSFET **200** since they have already been described above. The primary differences between the power MOSFETs **100** and **200** are that the heavily-doped p⁺ deep shielding patterns **240** that are included in power MOSFET **200** do not have the lateral extensions **142** that are included in the deep shielding patterns **140** of power MOSFET **100.**

The power MOSFET **200** may be fabricated by growing layers **120, 130** and **170** in a single epitaxial growth process. A series of trenches are then formed in the upper surface of the device. Every other one of these trenches serves as a gate trench **180** in the completed device **200.** A mask layer may then be formed on the device leaving the trenches that will not serve as gate trenches (i.e., every other trench) exposed, and an ion implantation process may be performed into the bottoms of these exposed trenches to form a plurality of heavily-doped p⁺ deep shielding patterns **240.** An additional epitaxial growth process may be performed to fill the trenches that will not serve as gate trenches with semiconductor material in order to form the heavily-doped p⁺ regions **174** of the p-wells **172.** An ion implantation step may then be performed to form the heavily-doped n⁺ source regions **160.** Then, the gate insulating layers **182** and the gate electrodes **184** may be formed in the same manner described above with reference to the power MOSFET **100.**

The design of the power MOSFET **200** overcomes various of the potential problems with the power MOSFET **100** that is described above. In particular, the MOSFET **200** avoids the alignment problem present in the fabrication of MOSFET **100,** and does not require a separate ion implantation step to form the heavily-doped p⁺ regions **174** of the p-wells **172.** One challenge, however, with the power MOSFET **200** is that it requires formation of twice as many trenches. Additionally, since the deep shielding patterns **240** in power MOSFET **200** do not include the lateral extensions **142** that are included in the deep shielding patterns **140** of MOSFET **100,** the electric field blocking performance of the power MOSFET **200** may not be as good as the electric field blocking performance of power MOSFET **100.**

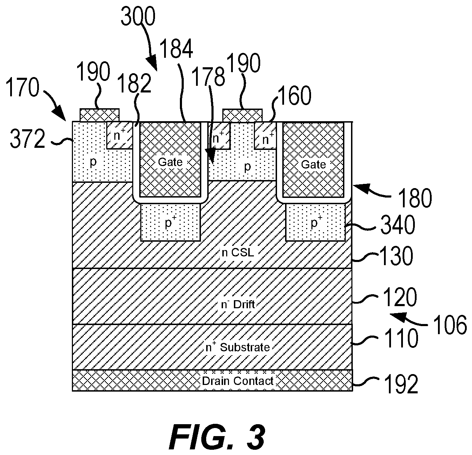

**FIG. 3** is a schematic cross-sectional diagram of a third conventional wide band-gap power MOSFET **300.** The power MOSFET **300** is similar in design to the power MOSFETs **100, 200** described above. Consequently, same or similar components of the power MOSFETS **100, 200, 300** have been labeled with the same reference numerals, and descriptions of these same/similar components will generally be omitted with respect to power MOSFET **300.**

The primary difference between the power MOSFETs **100, 200** and power MOSFET **300** is that the power MOSFET **300** includes deep shielding patterns **340** that are provided under each gate trench **180** as opposed to the deep shielding patterns **140, 240** that are provided under the p-wells **172** of power MOSFETs **100, 200.** The deep shielding patterns **340** may be very effective in protecting the corners of the gate insulating layer **182** from high electric fields during reverse blocking operation. However, one potential problem with providing the deep shielding patterns **340** is that they need to be electrically connected to the p-wells **372,** and it can be challenging to form a good electrical connection between the deep shielding pattern **340** and the p-wells **372.** Moreover, forming this electrical connection typically requires additional processing steps and/or may take up additional "real estate" in the device structure which may, for example, reduce the number of unit cells that can be included in the device.

Pursuant to embodiments of the present invention, gate trench wide band-gap power semiconductor devices such as power MOSFETs and power IGBTs are provided that have deep trench shielding patterns underneath the gate trenches that have good electrical connections to the well regions that are generally simple to manufacture. In some embodiments, the gate trench wide band-gap power semiconductor devices may be formed using an angled ion implantation that, in a single implantation process, forms both (1) the deep shielding patterns under the gate trenches and (2) deep shielding connection patterns that electrically connect the deep shielding patterns to well regions of the device. The techniques according to embodiments of the present invention may also be used to form termination structures such as, for example, guard rings in the termination region of the device so that the termination structures will extend to the same depth within the semiconductor layer structure as the deep shielding patterns that are formed in the active region of the device. This may further improve the performance of the device.

In example embodiments, the deep shielding patterns according to embodiments of the present invention may be formed by performing an angled ion implant after the gate trenches are formed. The angled ion implantation step implants dopant ions into at least portions of both the bottom surface and one sidewall of each gate trench, while not implanting ions into the other sidewall of each gate trench. Since the dopant ions are implanted into the bottom surface of each gate trench, which may already be more than 1-2 microns deep into the semiconductor layer structure, the deep shielding patterns can readily be implanted to a desired depth, and typically can be implanted using relatively low ion implantation energies. This may reduce damage to the lattice structure and may provide a more precise and uniform doping concentration in the deep shielding patterns. Moreover, since the dopant ions are implanted into one sidewall of each gate trench to form deep shielding connection patterns therein, an electrical connection is formed from each deep shielding pattern to a nearby well region. The opposite sidewall of the gate trench may not be implanted, and hence a channel for the device is still provided on one side of each gate trench.

Pursuant to further embodiments, a pair of angled ion implantation steps may be performed to form the above-described deep shielding patterns and deep shielding connection patterns. The first angled implant may implant dopant ions into a first sidewall and a bottom surface of the gate trenches, and the second angled implant may implant dopant ions into a second sidewall and the bottom surface of the gate trenches. Thus, in these embodiments, deep shielding connection patterns may be formed on both sidewalls of each gate trench. In these embodiments, the deep shielding patterns and the deep shielding connection patterns that extend alongside and underneath each gate trench may be segmented to have a plurality of spaced apart deep shielding regions and deep shielding connection regions under each gate trench. Channel regions may be provided in between the segmented deep shielding regions and deep shielding connection regions.

In still further embodiments, the gate trenches may have sloped sidewalls. When the gate trenches have such sloped sidewalls, the deep shielding patterns and deep shielding connection patterns may be formed using a vertical (i.e., not angled) ion implantation process, since one or both sidewalls of the gate trenches may be implanted without using an angled ion implant. An angled ion implantation may also be used in these embodiments.

The new approaches for forming deep shielding patterns disclosed herein allows the formation of deep shielding patterns that are at least twice as close together as compared to the deep shielding patterns **240** that are included in the power MOSFET **200** described above, since the deep shielding patterns **240** are only formed in the bottom of every other trench. Thus, the devices according to embodiments of the present invention may exhibit better electric field blocking and on-state resistance performance as compared to devices formed using the technique discussed above with respect to the power MOSFET **200** of **FIG. 2****.** Moreover, by forming the electrical connection between the deep shielding patterns below the gate trenches and the well regions in the same implantation step used to form the deep shielding patterns the problems discussed above with respect to the power MOSFET **300** of **FIG. 3** in forming this electrical connection can be avoided. The approaches according to embodiments of the present invention also avoid the need for the additional epitaxial growth step that is required in fabrication of the power MOSFET **100** of **FIG. 1** and the related alignment problems that occur when multiple epitaxial growth steps are performed. Additionally, the devices according to embodiments of the present invention form the deep shielding patterns directly below the gate trenches, where it may be more effective, which is not the case with the power MOSFETS **100, 200** of **FIGS. 1-2** above.

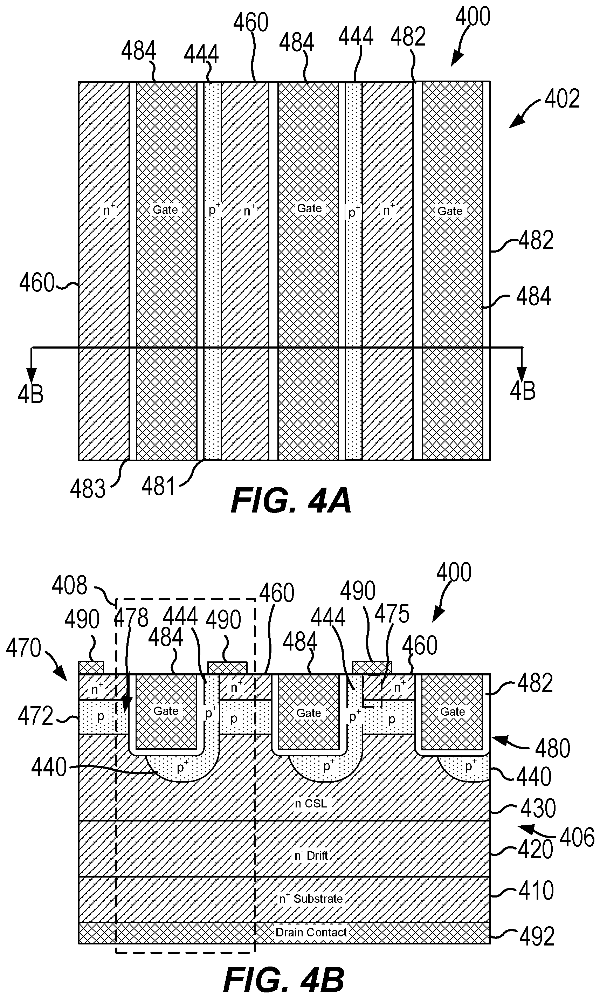

Embodiments of the present invention will now be described with reference to **FIGS. 4A-12****.** It will be appreciated that features of the different embodiments disclosed herein may be combined in any way to provide many additional embodiments. Thus, for example, features of any MOSFET embodiment described herein may be incorporated into any IGBT embodiments, and vice versa. As another example, each edge termination described herein may be used with any of the embodiments and not only with the embodiment that includes the specific edge termination. Thus, it will be appreciated that various features of the inventive concepts are described below with respect to specific examples, but that these features may be added to other embodiments and/or used in place of example features of other embodiments to provide many additional embodiments. Thus, the present invention should be understood to encompass these different combinations.

**FIG. 4A** is a schematic plan view of a gate trench power MOSFET **400** according to embodiments of the present invention. In the plan view of **FIG. 4A** the source contacts **490** are omitted to better show the underlying semiconductor layers. **FIG. 4B** is a schematic cross-sectional view of the gate trench power MOSFET **400** taken along line **4B-4B** of **FIG. 4A****.** In **FIGS. 4A** and **4B** any gate electrode/contact material that extends outside of the gate trenches has been omitted from the drawings to more clearly show other features of the MOSFET **400** and to simplify the drawings.

Referring first to **FIG. 4A**, the power MOSFET **400** includes an active region **402** and a termination region (not shown) that surrounds the active region **402**. **FIGS. 4A-4B** depict a single power MOSFET **400** that includes a plurality of unit cells **408** that are disposed in parallel. One example unit cell **408** is shown by the dotted box in **FIG. 4B****.** The power MOSFET **400** may include more unit cells **408** than the approximately three unit cells **408** shown in **FIG. 4B****.** It will also be appreciated that a plurality of power MOSFETs **400** may be grown on a single wafer.

As shown in **FIGS. 4A-4B****,** the power MOSFET **400** includes a heavily-doped (n⁺) n-type wide band-gap semiconductor substrate **410.** The substrate **410** may comprise, for example, a single crystal 4H silicon carbide semiconductor substrate. The substrate **410** may be doped with n-type impurities (e.g., an n⁺ silicon carbide substrate). The impurities may comprise, for example, nitrogen or phosphorous. The doping concentration of the substrate **410** may be, for example, between 1x10¹⁸ atoms/cm³ and 1x10²¹ atoms/cm³ although other doping concentrations may be used. The substrate **410** may be any appropriate thickness (e.g., between 100 and 500 microns thick in some embodiments).

A lightly-doped (n⁻) silicon carbide drift region **420** is provided on the substrate **410.** The silicon carbide drift region **420** may be formed by epitaxial growth on the silicon carbide substrate **410.** The silicon carbide drift region **420** may be a thick region, having a vertical height above the substrate **410** of, for example, 3-100 microns. An upper portion of the silicon carbide drift layer **420** may comprise an n-type silicon carbide current spreading layer **430.** The current spreading layer **430** may be formed, for example, by epitaxial growth in order to provide a moderately-doped current spreading layer **430** that has a doping concentration that exceeds the doping concentration of the remainder of the more lightly-doped n⁻ silicon carbide drift region **420.** The more lightly doped portion of the silicon carbide drift region **420** may have a doping concentration of, for example, between 1x10¹⁶ atoms/cm³ and 5x10¹⁷ atoms/cm³, although other doping concentrations may be used. The current spreading layer **430** may have a doping concentration of, for example, between 1x10¹⁷ atoms/cm³ and 5x10¹⁸ atoms/cm³, although other doping concentrations may be used. In some embodiments, a doping concentration of the current spreading layer **430** may be at least an order of magnitude greater than a coping concentration of the more lightly doped portion of the silicon carbide drift region **420.**

A moderately doped p-type silicon carbide layer **470** is formed on the current spreading layer **430.** The moderately doped p-type silicon carbide layer **470** may formed during the same epitaxially growth step used to form the n-type current spreading layer **430,** with the n-type dopant source gas turned off and a p-type dopant source gas turned on. In other embodiments, an undoped (or slightly doped) epitaxial layer may be grown via epitaxial growth on the current spreading layer **430** and then the moderately doped p-type silicon carbide layer **470** may be formed by implanting p-type dopant ions into this layer. The ion implantation approach requires an additional processing step, but may provide more consistent doping levels throughout the moderately doped p-type silicon carbide layer **470.** The moderately doped p-type silicon carbide layer **470** may have a doping concentration of, for example, between 5x10¹⁶/cm³ and 5x10¹⁷/cm³. The layers **410, 420, 430, 470** may all be grown in a single epitaxial growth process with process stops to switch between n-type doping and p-type doping to form a semiconductor layer structure **406.**

Heavily-doped (n⁺) n-type silicon carbide source regions **460** may be formed in upper portions of moderately doped p-type silicon carbide layer **470.** The n-type source regions **460** may be formed by, for example, ion implantation. The heavily-doped (n⁺) n-type silicon carbide regions **460** act as the source regions for the MOSFET **400.** The drift region **420**/current spreading layer **430** and the substrate **410** together act as a common drain region for the power MOSFET **400.**

Gate trenches **480** are etched through (or beside) the n⁺ silicon carbide regions **460,** through the moderately doped p-type silicon carbide layer **470,** and into the upper surface of the n-type silicon carbide current spreading layer **430.** The gate trenches **480** may convert the moderately doped p-type silicon carbide layer **470** into a plurality of p-type well regions ("p-wells") **472** that are provided between the gate trenches **480.** The gate trenches **480** may have a U-shaped cross-section in some embodiments, as shown in **FIG. 4B****.** The rounding of the bottom edges of the gate trenches **480** may help reduce the electrical fields at the bottom corners of the gate trenches **480.** The rounded corners may be omitted in some embodiments.

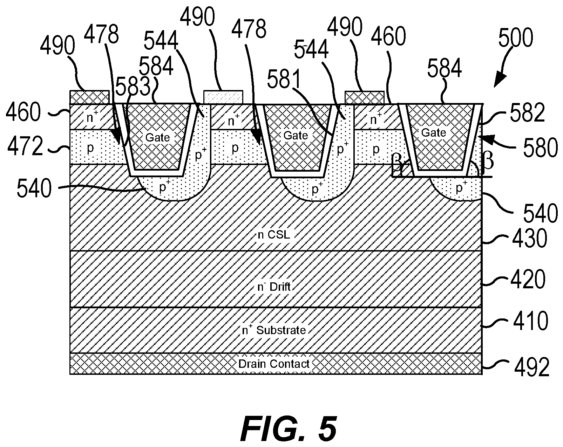

Each gate trench **480** may have a first sidewall **481** and a second sidewall **483** that is opposite the first sidewall **481.** The first and second sidewalls **481, 483** each extend in a first direction along the upper surface of the semiconductor layer structure **406.** Each sidewall **481, 483** comprises a portion of the semiconductor layer structure **406** that defines a side portion of a gate trench **480** (i.e., slightly sloped sidewalls). The first and second sidewalls **481, 483** may be substantially vertical sidewalls in some embodiments, In other embodiments, the first and second sidewalls **481, 483** may have angles of slightly more than ninety degrees with respect to the bottom surface of the gate trenches **480.** This increased angle may result, for example, from the etching process used to form the gate trenches **480** (as the top portions of the sidewalls may be etched away more than the bottom portions). In still other embodiments, the first and second sidewalls of the gate trenches may be intentionally designed to have sidewalls with more pronounced slopes as will be explained with reference to **FIG. 5****.**

After the gate trenches **480** are formed, a mask is formed to protect the heavily-doped n⁺ source regions. Then, p-type dopants are implanted into the top surface of the device to form a plurality of heavily-doped deep shielding patterns **440** and a plurality of heavily-doped deep shielding connection patterns **444.** As known to those skilled in the art, ions such as n-type or p-type dopants may be implanted in a semiconductor layer or region by ionizing the desired ion species and accelerating the ions at a predetermined kinetic energy as an ion beam towards the surface of a semiconductor layer in an ion implantation target chamber. Based on the predetermined kinetic energy, the desired ion species may penetrate into the semiconductor layer to a certain depth.

The deep shielding patterns **440** are formed underneath the respective gate trenches **480** in the upper surface of the n-type drift region **420**/current spreading layer **430** and the deep shielding connection patterns **444** are formed in first sidewalls **481** of the gate trenches **480.** Each deep shielding connection pattern **444** may extend from a respective one of the deep shielding patterns **440,** through a p-well **472** to the top surface of the semiconductor layer structure **406.** Each deep shielding connection pattern **444** may electrically connect a respective one of the deep shielding patterns **440** to a respective p-well **472.** The p-type silicon carbide shielding patterns **440** may extend to, for example, a depth of approximately 1-2 microns into the drift layer **420**/current spreading layer **430,** although other depths may be used (e.g., 0.5 to 3 microns or 1 to 3.5 microns). Each deep shielding pattern **440** may have an associated deep shielding connection pattern **444.** The deep shielding patterns **440** and their associated deep shielding connection patterns **444** may extend in a first direction in which the gate trenches extend along the upper surface of the semiconductor layer structure **406.** The deep shielding patterns **440** and their associated deep shielding connection patterns **444** may be spaced apart from each other in a second direction that is perpendicular to the first direction.

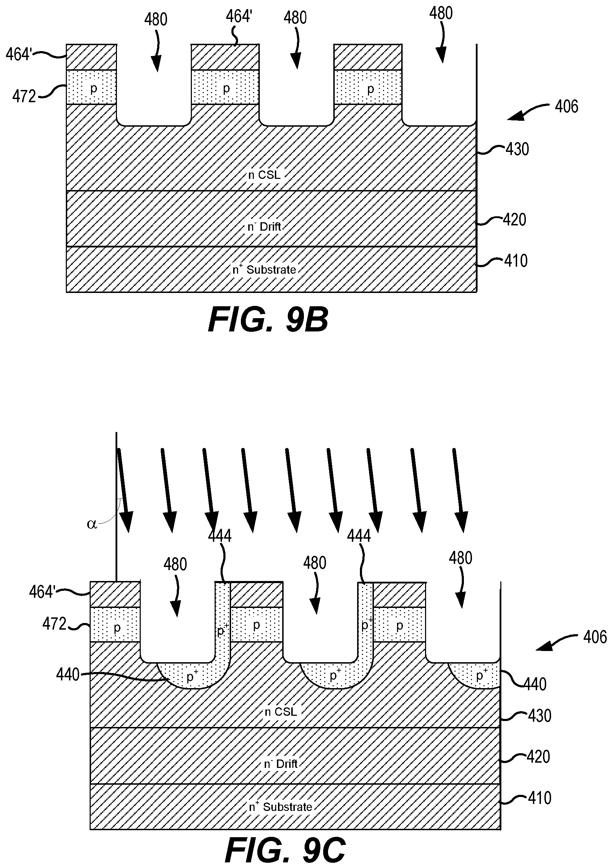

The deep shielding patterns **440** and the deep shielding connection patterns **444** may be formed using an angled ion implant in some embodiments. The implant angle α is defined as the angle at which the ions are implanted from an axis that is perpendicular to the upper surface of the device (see **FIG. 9C**). In some embodiments, the implant angle α may be small, such as between 2 and 15 degrees. In other embodiments, the implant angle α may be between 15 and 45 degrees. In still other embodiments, the implant angle α may be between 45 and 80 degrees. This may allow a deep p-type implant underneath most of each gate trench **480,** while still ensuring that one sidewall **481** of each gate trench **480** is implanted while the other sidewall **483** is not. In some embodiments, the same mask layer that is used in etching the gate trenches **480** may be used as the ion implantation mask during the formation of the deep shielding patterns **440** and the deep shielding connection patterns **444.** It will be appreciated that the angle of implantation α and/or the energy of the implant may be varied during the angled ion implant in order to achieve desired doping levels and doping depths both underneath the gate trenches **480** and into the first sidewalls **481** of the gate trenches **480.** For example, the implant may have higher energies at lower implant angle(s) and lower energies at higher implant angle(s).

A gate insulating layer **482** such as a silicon oxide layer is formed on the bottom surface and sidewalls of each gate trench **480.** A gate electrode **484** is formed on each gate insulating layer **482.** Each gate electrode **484** may fill the remainder of its respective gate trench **480.** The gate electrodes **484** may comprise, for example, a semiconductor gate electrode or a metal gate electrode. The orientation, size and shape of the gate trenches **480** may be selected to provide a desired balance between the channel resistance in the on-state and the voltage blocking performance in the off-state.

Source contacts **490** may be formed on top surfaces of the heavily-doped n-type source region **460** and the heavily-doped deep shielding connection patterns **444.** The source contacts **490** may all be electrically connected to form a single source contact. A drain contact **492** may be formed on the lower surface of the substrate **410.** The source and drain contacts **490, 492** may comprise, for example, metal contacts. A gate contact (not shown) may be electrically connected to each gate electrode **484.**

A heavily-doped p-type region **475** may be formed in the upper portion of each p-well **472** between the deep shielding connection pattern and the source regions **460** (which reduces the width of the source regions **460**). While the heavily-doped p-type region **475** is not included in the embodiment of **FIGS. 4A-4B****,** a dotted box labelled **475** has been included in one of the unit cells **408** of **FIG. 4B** to illustrate where this region could be located in each unit cell when included. Such heavily-doped p-type regions **475** may be provided if, for example, the width of the deep shielding connection patterns **444** is not sufficiently wide to guarantee that each deep shielding connection pattern **444** will be in direct contact with an associated source contact **490.**

Vertical channel regions **478** are formed in the p-wells **472** adjacent the gate insulating layer **482** along one side of each gate trench **480** (namely in the second sidewall **483** of each gate trench **480**). Current may flow from the n-type source regions **460** through the channel regions **478** to the drift region **420**/current spreading layer **430** when a voltage is applied to the gate electrodes **484.** Channels are not provided on the other side of each gate electrode **484** (e.g., in the first sidewall **481** of each gate trench **480**) as instead, p-type deep shielding connection patterns **444** are formed in the first sidewalls **481** that electrically connect the respective p-type deep shielding patterns **440** to the p-wells **472** and the source contacts **490.**

The p-type silicon carbide deep shielding patterns **440** may help reduce the extent to which the electric field that forms in the drift region **420** when the device is operated in the reverse blocking state (i.e., when the device is turned off) extends upward toward the gate insulating layers **482.** The electric field, if too high, may over time degrade lower portions of the gate insulating layers **482,** which may eventually result in device failure.

The power MOSFET **400** may exhibit several advantages over conventional power MOSFET designs such as the power MOSFET designs discussed above with reference to **FIGS. 1-3****.** First, the MOSFET **400** includes deep p-type shielding patterns **440** below the gate trenches **480.** This may provide enhanced electric field blocking as compared to the power MOSFETs of **FIGS. 1** and **2****,** which have deep shielding patterns that are under the p-wells instead of under the gate trenches. Second, the power MOSFET **400** may have good electrical connections in the form of deep shielding connection patterns **444** that extend between the p-type deep shielding patterns **440** and the p-wells **472** and source electrodes **490,** and these connections may be formed in the same processing step used to form the p-type deep shielding patterns **440.** Third, all of the epitaxial layers may be formed in the same step, which may simplify fabrication of the MOSFET **400** as compared to, for example, the power MOSFET **100** of **FIG. 1** above. Fourth, the power MOSFET **400** has high conductivity p-type connection to the deep shielding patterns **440** within the active region **402** of the device **400.** Fifth, the power MOSFET **400** requires only half the number of trenches as are required in the power MOSFET **200** of **FIG. 2****.** Sixth, the power MOSFET **400** does not require precise alignment in the manner that the power MOSFET **100** requires.

The structure of the power MOSFET **400** may be particularly advantageous with respect to silicon carbide based MOSFETs that are formed on faces of the silicon carbide crystal that have high electron mobility which are perpendicular to the C-axis, such as the A-face {11-20} and the M-face {1-100}.

**FIG. 5** is a schematic cross-sectional diagram of a gate trench power MOSFET **500** according to further embodiments of the present invention. The power MOSFET **500** has V-shaped gate trenches **580** as opposed to the gate trenches **480** of power MOSFET **400** that have nearly vertical sidewalls. As the power MOSFET **500** is similar to the power MOSFET **400** discussed above with reference to **FIGS. 4A-4B****,** like elements of power MOSFET **500** are numbered using the same reference numerals, and will not be discussed further below as they have already been described above. The discussion that follows will focus on the differences between the power MOSFET **500** and the power MOSFET **400.**

As can be seen by comparing **FIGS. 4B** and **5****,** the primary difference between power MOSFETs **400** and **500** is that power MOSFET **500** includes V-shaped gate trenches **580** that have sloped first and second sidewalls **581, 583.** The angle of each sidewall is defined herein as the angle β between the bottom surface of the gate trench **580** and the sidewall. Gate insulating layers **582** and gate electrodes **584** may be formed in the gate trenches **580.** The gate insulating layers **582** and gate electrodes **584** may be identical to the gate insulating layers **482** and gate electrodes **484** that are described above with respect to the MOSFET **400** except that they have a different shape so as to conform to the gate trenches **580.** The trenches **580** are narrower in width at the bottom and wider in width at the top. To form the power MOSFET **500,** the ion implantation angle α that is used during the ion implantation step for forming the deep shielding patterns **540** and the deep shielding connection patterns **544** may be larger to ensure that the silicon carbide layer along the first sidewall **581** of the gate trench **580** is sufficiently implanted all the way to the top surface of the device. Additionally, the deep shielding patterns **540** and the deep shielding connection patterns **544** may be skewed more to one side than is the case with the deep shielding patterns **440** and the deep shielding connection patterns **444** that are included in the power MOSFET **400.** Because of the larger implantation angle α, better electrical connections may be made to the deep shielding regions **540.**

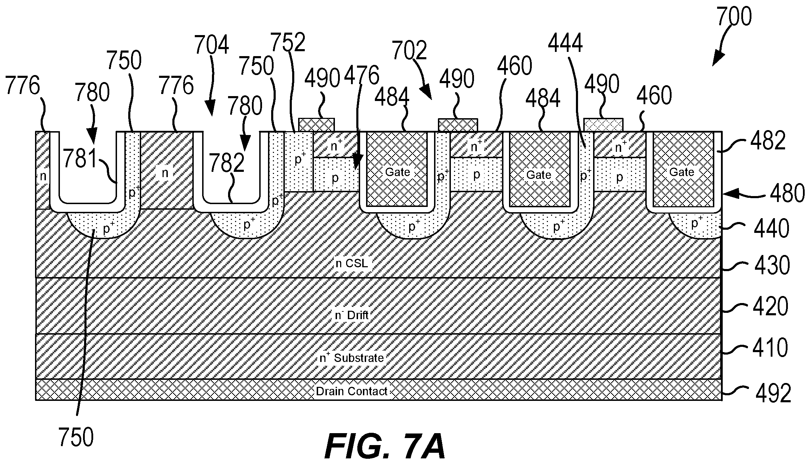

While, the power MOSFET **500** may be formed using an angled implant, in other embodiments, a perpendicular implant may be used where the implantation angle α is 0 degrees. The angled sidewalls **581, 583** of the gate trenches **580** allow implantation into the silicon carbide forming the first sidewall **581** of each gate trench **580.** A mask may be used to prevent implantation into the second sidewalls **583** of each gate trench **580.** One advantage of using an angled ion implant to form the deep shielding patterns **540** and the deep shielding connection patterns **544** is that when an angled ion implant is used the same mask that is used during the etching step that forms that gate trenches **580** may be used as the ion implantation mask. However, the complications that the angled implant may have on formation of an edge termination that are discussed below with reference to **FIGS. 7A-7B** may generally be avoided when a perpendicular implant is performed instead of an angled implant.

The structure of the power MOSFET **500** may be particularly advantageous with respect to silicon carbide based MOSFETs that are formed on faces of the silicon carbide crystal that have high electron mobility and that are not perpendicular to the C-axis, such as the R-face angled at 54.7 degrees.

In the embodiments of **FIGS. 4A-4B** and **5,** the ion implantation angle α may involve a tradeoff between the width of the deep shielding patterns **440, 540** and the width of the deep shielding connection patterns **444, 544.** If the implant angle α is selected to be just greater than the angle of the sidewalls of the gate trenches **480, 580** with respect to an axis that is perpendicular to the top surface of the device, then the width of the deep shielding patterns **440, 540** may be maximized, but little implantation will occur into the sidewall of the gate trenches **480, 580.** Thus, the angle of implantation α is increased to obtain sufficient implantation into the sidewall in order to form the deep shielding connection patterns **444, 544,** but this decreases the width of the deep shielding patterns **440, 540.**

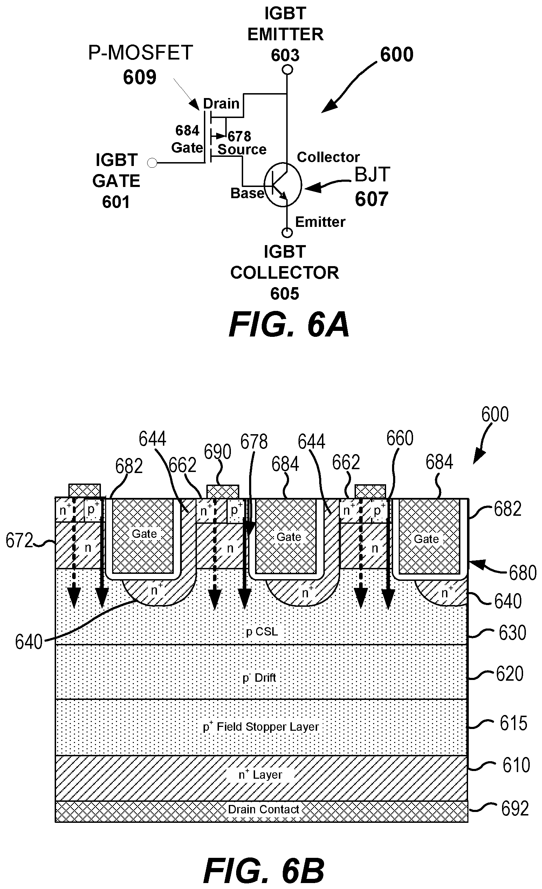

**FIG. 6A** is a simplified circuit diagram of a p-channel silicon carbide power IGBT **600** according to embodiments of the present invention. **FIG. 6B** is a schematic cross-sectional diagram of the IGBT **600** of **FIG. 6A****.**

As shown in **FIG. 6A****,** the IGBT **600** includes an n-p-n silicon carbide power BJT **607** that has a base, an emitter and a collector. The IGBT **600** further includes a silicon carbide MOSFET **609** having a gate, a source and a drain. The source of the silicon carbide MOSFET **609** is electrically connected to the base of the silicon carbide power BJT **607,** and the drain of the silicon carbide MOSFET **609** is electrically connected to the collector of the silicon carbide power BJT **607.** By convention, the collector of the BJT **607** is the emitter **603** of the IGBT **600,** and the emitter of the BJT **607** is the collector **605** of the IGBT **600,** and the gate **684** of the MOSFET **609** is the gate **601** of the IGBT **600.**

The IGBT **600** may operate as follows. An external drive circuit (not shown) is connected to the gate **601** of the IGBT **600** for applying a gate bias voltage to the MOSFET **609.** When this external drive circuit applies a voltage to the gate **601** of IGBT **600** that is greater than the threshold voltage of the MOSFET **609,** an inversion layer is formed in a semiconductor layer that is beside the gate **601** which acts as a channel **678** that electrically connects the p⁺ emitter **603** of the IGBT **600** to the base of BJT **607.** Note that the gate 601 of IGBT **600** is the gate **684** of MOSFET **609.** Holes are injected from the p⁺ emitter region **603** through the channel **676** into the base of BJT **607.** This hole current acts as the base current that drives the BJT **607.** In response to this hole current, electrons are injected from the collector **605** of IGBT **600** across the base of BJT **607** to the emitter **603** of IGBT **600.** Thus, the silicon carbide MOSFET **609** converts the silicon carbide power BJT **607** from a current driven device to a voltage driven device, which may allow for a simplified external drive circuit. The silicon carbide MOSFET **609** acts as a driver transistor, and the silicon carbide power BJT **607** acts as the output transistor of the IGBT **600.**

**FIG. 6B** is a schematic cross-sectional diagram of a portion of the IGBT **600** of **FIG. 6A** that illustrates several unit cells of the power IGBT **600.** It will be appreciated that to form the power IGBT **600,** typically a large number of unit cells are implemented in parallel. The IGBT **600** may also include a termination region. An example embodiment of a suitable termination region for power semiconductor devices according to embodiments of the present invention is discussed below with reference to **FIGS. 7A-7B****.** It will be appreciated that the termination region shown in **FIGS. 7A-7B** may be included in the IGBT **600** of **FIGS. 6A** and **6B****.**

As shown in **FIG. 6B****,** the IGBT **600** may be formed on, for example, a heavily-doped n⁺ n-type silicon carbide layer **610.** This n⁺ silicon carbide layer **610** acts as the collector **605** of the IGBT **600** (and hence also as the emitter of the BJT **607**). A p⁺ silicon carbide field stopper layer **615** may optionally be provided on layer **610.** A lightly doped (p⁻) p-type silicon carbide drift layer **620** is provided on the field stopper layer **615.** A moderately-doped p-type silicon carbide current spreading layer **630** is provided in the upper portion of the drift region **620.** The p-type silicon carbide layers **615, 620, 630** act as the base of the BJT **607** and as the source region of the MOSFET **609.** The silicon carbide layers **610, 615, 620, 630** may be formed via epitaxial growth on a substrate (not shown) that is subsequently removed.

A moderately-doped n-type silicon carbide layer **670** may be formed above the p-type silicon carbide current spreading layer **630** via epitaxial growth. This moderately-doped n-type silicon carbide layer **670** will be used to form a plurality of n-wells **672** in the device. Gate trenches **680** are formed in the moderately-doped n-type silicon carbide layer **670** to define the n-wells **672.** The gate trenches **680** may also extend into the upper surface of the p-type current spreading layer **630.** The gate trenches **680** may each have a U-shaped cross-section.

Heavily-doped n-type silicon carbide deep shielding patterns **640** are formed underneath each of the gate trenches **680,** and heavily-doped n-type silicon carbide deep shielding connection patterns **644** are formed in the first sidewalls of the gate trenches **680.** These regions **640, 644** may be formed using the angled ion implantation techniques according to embodiments of the present invention in the same manner that the regions **440, 444** of power MOSFET **400** are formed (except that regions **640, 644** are doped n-type instead of p-type). If the gate trenches **680** are instead formed to have sloped (non-vertical) sidewalls, then the deep shielding patterns **640** and the deep shielding connection patterns **644** can be formed using a vertical ion implantation step instead of an angled ion implantation as discussed above with reference to MOSFET **500.**

Next, an upper portion of each n-well **672** may be doped by ion implantation to form a heavily-doped n⁺ silicon carbide emitter region **662** (which also acts as the collector of the BJT **607**). Heavily-doped (p⁺) p-type silicon carbide drain regions **660** may be formed in upper portions of the n-wells **672** adjacent the respective heavily-doped n-type silicon carbide emitter regions **662** by ion implantation. Each p-type drain region **660** may be directly adjacent and contacting a respective one of the more heavily-doped n-type silicon carbide emitter region **662.** The p⁺ silicon carbide drain regions **660** act as a common drain for the IGBT **600.** An ohmic contact **690** is formed to contact the n⁺ silicon carbide emitter region **662** and the p⁺ silicon carbide drain region **660,** and an ohmic contact **692** is formed on the back side of the n⁺ silicon carbide substrate **610.**

A gate insulating layer **682** such as a silicon oxide layer is formed on the bottom surface and sidewalls of each gate trench **680.** A gate electrode **684** that acts as the gate **601** of the IGBT **600** is formed on each gate insulating layer **682** to fill the respective gate trenches **680.** The gate electrodes **684** may comprise, for example, a semiconductor gate electrode or a metal gate electrode. A gate contact (not shown) may be electrically connected to each gate electrode **684.**

Vertical channel regions **678** of the MOSFET **609** are provided in the n-wells **672** adjacent one side of each gate electrode **684.** These vertical channels **678** extend between the p⁺ drain regions **660** and the p-type current spreading layer **630.**

Operation of the IGBT **600** will now be discussed. When a bias voltage that exceeds the threshold voltage of the MOSFET **609** is applied to the gate **601,** a hole current flows across the channels **678** of MOSFET **609** into the base of the BJT **607,** as indicated by the solid bold arrows in **FIG. 6B****.** In response to this base current, an electron current (shown by the dashed arrows in **FIG. 6B**) flows from the heavily-doped n-type emitter region **662** of the IGBT **600** through the n-wells **670** to the collector **605** of the IGBT **600.**

While **FIGS. 6A-6B** illustrate a p-channel IGBT, it will be appreciated that n-channel IGBTs may also be provided pursuant to embodiments of the present invention. For example, the MOSFET **400** depicted in **FIGS. 4A-4B** could be converted into an n-channel IGBT according to embodiments of the present invention simply by replacing the n+ substrate **410** with a p-type semiconductor layer (e.g., a heavily doped p-type semiconductor layer).

**FIG. 7A** is a schematic cross-sectional diagram of a gate trench power MOSFET **700** according to further embodiments of the present invention that illustrates an edge termination that is formed in a termination region **704** of the device. The power MOSFET **700** may be identical to the power MOSFET **400** described above, except that the power MOSFET **700** has a termination region **704** that includes a plurality of guard rings **750.** The guard rings **750** may be formed underneath the bottom surfaces of termination trenches **780** that are formed in the termination region **704** of the MOSFET **700** and in first sidewalls **781** of the termination trenches **780.** As the active region **702** of power MOSFET **700** may be identical to the active region **402** of power MOSFET **400** discussed above with reference to **FIGS. 4A-4B****,** the discussion below will focus on the termination region **704** of the MOSFET **700.** While the guard rings **750** are formed underneath and in sidewalls of the termination trenches **780** in this particular embodiment, as shown herein this need not be the case in other embodiments.

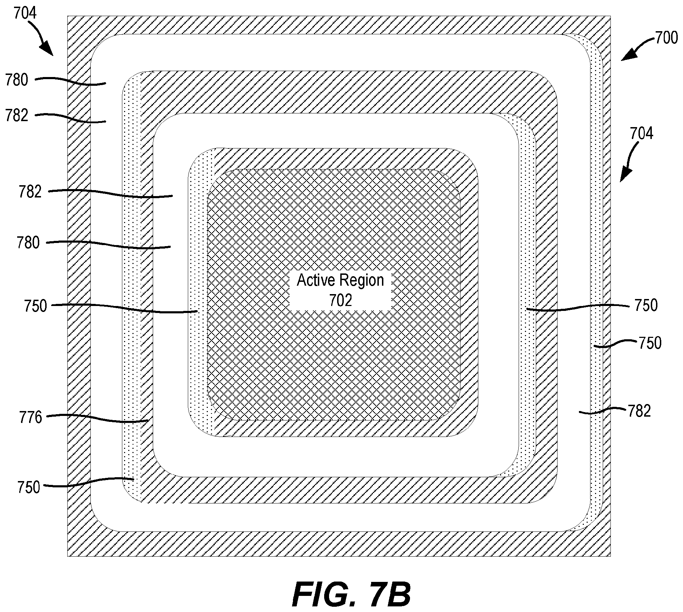

As shown in **FIG. 7A****,** the power MOSFET **700** includes a plurality of guard rings **750** that are formed in the termination region **704** of the device. In the plan view of **FIG. 7B****,** the lower portions of the guard rings **750** are underneath passivating insulating layers **782** that are formed in the termination trenches **780** and hence only the upper portion of each guard ring **750** that is formed in the first sidewall **781** of each termination trench **780** is visible. The termination trenches **780** may be formed simultaneously with the gate trenches **480** and the guard rings **750** may be formed simultaneously with the deep shielding patterns **440** and the deep shielding connection patterns **444.** As a result, the guard rings **750** may extend the same depth into the current spreading layer **430** as the deep shielding patterns **440.** Having the guard rings **750** (or other termination structure) extend to the same depth into the drift region **420**/current spreading layer **430** as the deep shielding patterns **440** in the active region **702** of the device may provide improved blocking performance during reverse bias operation. As shown in **FIG. 7A****,** in the termination region **704,** the gate electrodes **484** and source contacts **490** that are provided in the active region **702** are omitted.

The guard rings **750** are formed in the termination region **704** to surround the active region **702.** Thus, as shown in **FIG. 7B****,** each guard ring **750** may have, for example, a generally circular or generally square shape when viewed from above. If the guard rings **750** have a generally square shape, the corners may be rounded to reduce electric field crowding. In order to form guard rings **750** that have such rounded corners, the termination trenches **780** may be formed to have rounded corners since the guard rings **750** are formed by implanting into the bottom surfaces and sidewalls of the termination trenches **780.** The guard rings **750** may comprise edge termination structures. When a power semiconductor device such as the power MOSFET **700** is operated in the blocking state, leakage currents may begin to flow at the edges of the active region as the voltage is increased. Leakage currents tend to flow in these edge regions because electric field crowding effects at the edge of the device may result in increased electric fields in these regions. If the voltage on the device is increased past the breakdown voltage to a critical level, the increasing electric field may result in runaway generation of charge carriers within the semiconductor device, leading to avalanche breakdown. When avalanche breakdown occurs, the current increases sharply and may become uncontrollable, and an avalanche breakdown event may damage or destroy the semiconductor device.

In order to reduce this electric field crowding (and the resulting increased leakage currents), edge termination structures such as the guard rings **750** may be provided that surround part or all of the active region **702** of the power MOSFET **700.** These edge termination structures may be designed to spread the electric field out over a greater area, thereby reducing the electric field crowding. Guard rings are one known type of edge termination structure. As shown in **FIGS. 7A-7B****,** the guard rings **750** may comprise spaced-apart p-type regions in the n-type current spreading layer **430.** While **FIG. 7A** illustrates a power MOSFET **700** that uses two guard rings **750** as an edge termination structure, it will be appreciated that different numbers of guard rings **750** may be used, and that other edge termination structures may be used. For example, in other embodiments, the guard rings **750** may be replaced with a junction termination extension. It will also be appreciated that the edge termination structure may be omitted in some embodiments.

In some embodiments, a second ion implantation step may be performed to tune the edge termination. The secondary ion implantation step may implant ions into the upper surface of the termination region **704** of the MOSFET **700.** The secondary ion implantation step may implant either n-type or p-type dopant ions into the device depending upon the tuning necessary. As shown in **FIG. 7A****,** the semiconductor regions **776** between the guard rings **750** may comprise n-type regions. As is also shown in **FIG. 7A****,** a passivating insulating layer **782** may be applied in the termination region **704.** The passivating insulating layer **782** may be formed simultaneously with the gate insulating layer **482.** In some embodiments, each passivating insulating layer **782** may fill its respective termination trench **780.** A heavily-doped p-type transition region **752** may be provided between the active region **702** and the termination region **704.** The p-type transition region **752** may be formed by removing a portion of the mask during the ion implantation step that is performed to form the deep shielding regions **440** and the guard rings **750.** It may also be formed by a separate implant in some embodiments.

**FIG. 7B** is a schematic plan view of the gate trench power MOSFET **700** of **FIG. 7A** that illustrates the structure of the termination region **704** of the device. In **FIG. 7B** the structural characteristics of the active region **702** are not illustrated and the active region **702** is depicted as being smaller than it would typically be in order to better illustrate details of the termination region **704.**

As shown in **FIG. 7B****,** two termination trenches **780** surround the active region **702.** The termination trenches **780** may be formed in the upper surface of the semiconductor layer structure. The upper portion of the semiconductor layer structure may comprise, for example, an undoped semiconductor material or a lightly doped n-type or p-type semiconductor material. In the depicted embodiment, the uppermost portion of the semiconductor layer structure is lightly-doped n-type as grown.

As is further shown in **FIG. 7B****,** the passivating insulating layer **782** is formed on the sidewalls and bottom surface of each termination trench **780** in the depicted embodiment. The passivating insulating layer **782** may be omitted in other embodiments, or replaced with a different material. As shown on the left side of **FIG. 7A****,** the right sidewalls of the two termination trenches **780** are implanted with p-type dopants via the angled ion implant. As shown in the left side of **FIG. 7B****,** the right sidewalls shown in **FIG. 7A** correspond to inner sidewalls of the respective termination trenches **780.** As is shown, however, in the right side of **FIG. 7B****,** on the opposite side of the active region **702,** the angled ion implant again implants the p-type dopants into the right sidewall of the termination trenches **780,** but on the left side of the device in **FIG. 7B****,** the right sidewalls are the outer sidewalls of the termination trenches **780.** Moreover, the sidewalls of the termination trenches **780** at the top and bottom of **FIG. 7B** may not be implanted on either side by the angled ion implantation step. This non-uniform implantation of the sidewalls is a result of the angled ion implantation on trenches that surround the active region **402.**

In order for the guard rings **750** to operate properly, the locations of the portions of the termination trenches **780** that are on different sides of the active region **702** may be varied so that they are not the same on each of the four sides of the active region **702.** For example, in the embodiment of **FIGS. 7A-7B****,** the portions of termination trenches **780** on the right side of **FIG. 7B** may be located slightly closer to the active region **702** than the portions of the termination trenches **780** on the left side of **FIG. 7B** to account for the fact that the outer sidewalls of the portions of the termination trenches **780** are implanted on the right side of **FIG. 7B** and the inner sidewalls of the portions of the termination trenches **780** are implanted on the left side of **FIG. 7B****.** The distance of the portions of the termination trenches **780** that are above and below the active region **702** in the plan view of **FIG. 7B** and/or the width of these portions of the termination trenches **780** may be made different from the distances and widths of the portions of the termination trenches **780** on the right and left sides of **FIG. 7B** to account for the fact that the sidewalls of the portions of the termination trenches **780** that are above and below the active region in **FIG. 7B** are not implanted. For example, the portions of the termination trenches **780** that are above and below the active region **780** may be wider than the portions of the termination trenches **780** on the right and left sides of **FIG. 7B** to achieve charge balance throughout the termination region **704.**

In other embodiments, instead of forming termination trenches **780** in the termination region **704,** a mesa etch may be performed throughout the termination region **704** so that the regions labelled **776** in **FIG. 7A** and the upper portions of the guard rings **750** are removed throughout the termination region **704** (and the active region **702** is a mesa that extends above the termination region **704**). The mesa etch in the termination region **704** may be to the same depth as the etch of the gate trenches **480** in the active region **702.** When this approach is taken, the termination region **704** may be masked with a mask pattern during the ion implantation step so that the guard rings **750** are formed in desired regions. The widths of the openings in the mask may not be symmetrical with respect to the active region **702** so that the guard rings **750** that are formed by the ion implantation step will be charged balance around the periphery of the active region **702.**

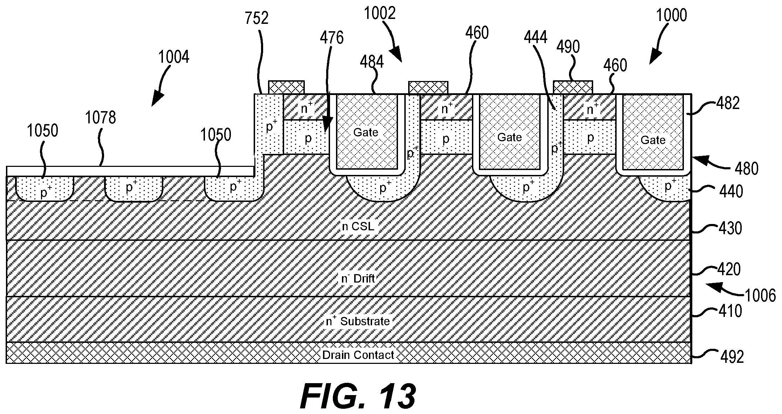

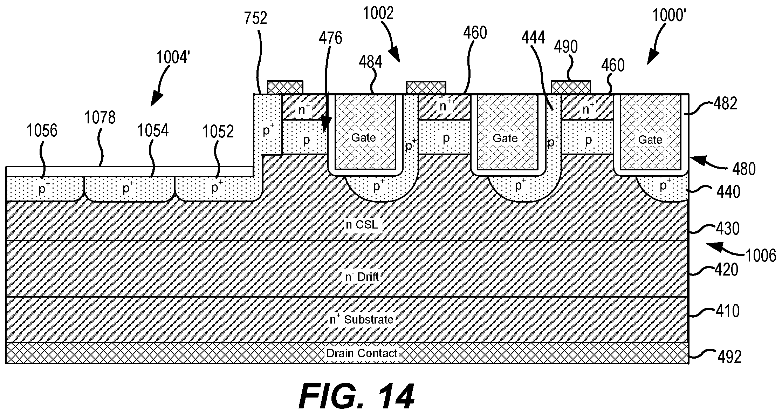

**FIGS. 13-14** illustrate two example power MOSFETs according to further embodiments of the present invention in which the devices are formed by performing a mesa etch in the termination region. In particular, **FIGS. 13** and **14** are schematic cross-sectional views of gate trench power MOSFETs having guard ring and junction termination extension edge terminations, respectively, that are formed after a mesa etch is performed throughout the termination regions of the devices.

Referring first to **FIG. 13****,** a power MOSFET **1000** according to embodiments of the present invention is illustrated that may be similar to the power MOSFET 700 that is described above with reference to **FIGS. 7A-7B****.** However, in the power MOSFET **1000,** during the etching step that is used to form the gate trenches **480** in the active region **1002** of the device **1000** a so-called "mesa etch" is performed in the termination region **1004** of the device **1000** that may be used to completely etch away the upper portion of the semiconductor layer structure **1006** in the termination region **1004.** Such an etching process is referred to as a mesa etch because after the etch is completed the active region **1002** is a mesa that rises above the surrounding termination region **1004.**

The active region **1002** of power MOSFET **1000** may be identical to the active region **702** of power MOSFET **700,** and hence further description thereof will be omitted herein. The termination region **1004** of MOSFET **1000,** however, differs from the termination region **704** of MOSFET **700,** as it does not include the termination trenches **780,** nor does it include structures having implanted sidewalls with the exception of the sidewall of the mesa in which the active region **1002** is formed.

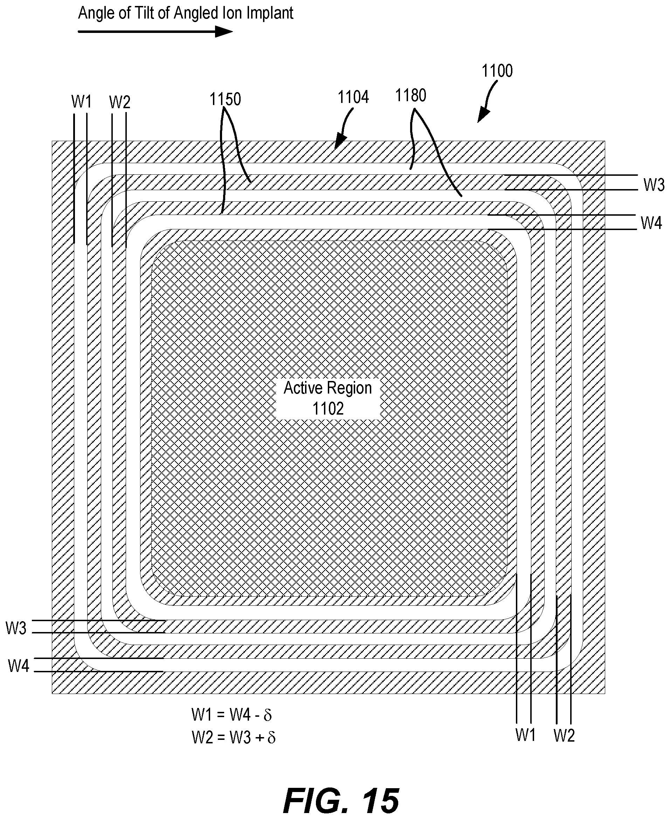

As shown in **FIG. 13****,** the edge termination may comprise a plurality of guard rings **1050** that are formed to surround the active region **1002.** The guard rings **1050** may have the general shape of the guard rings **1150** illustrated in **FIG. 15** (see discussion below) in that the guard rings **1050** may surround the active region **1002,** may have rounded corners, and may in some embodiments have a generally square or rectangular shape (with the rounded corners). A passivation layer **1078** such as, for example, a silicon oxide layer or a silicon nitride layer, may be formed over the guard rings 1050 in the termination region **1004** to protect the guard rings **1050.**

One potential advantage of the power MOSFET **1000** as compared to the power MOSFET **700** is that it may be easier to determine the layout of the guard rings **1050** that will result in proper charge balance. While the implanted sidewalls of the termination trenches **780** in MOSFET **700** do not have a significant impact on the charge balance, they do have some effect, and this must be taken into account in the design of the guard rings **750.** Additionally, the angled ion implant into the termination trenches **780** in the power MOSFET **700** impacts the width of the bottom of the implanted area, and does so differently in different regions of the termination region **704** (based upon whether the termination structure is parallel or perpendicular to the direction of tilt of the angled ion implant). Moreover, as discussed above with reference to **FIG. 7B****,** the sidewalls of only some portions of the termination trenches **780** are implanted, which complicates the design. The absence of termination trenches and/or implanted sidewalls in the termination region **1004** of MOSFET **1000** may thus simplify the design thereof. Thus, when a mesa etch is performed in the termination region, it may be possible to use a completely symmetric edge termination (e.g., either guard rings or a junction termination extension) and still achieve acceptable charge balance.

**FIG. 14** is a schematic cross-sectional view of a power MOSFET **1000'** that is a slightly modified version of the power MOSFET **1000** of **FIG. 13****.** As can be seen by comparing **FIGS. 13** and **14****,** the difference is that MOSFET **1000'** includes a junction termination extension edge termination in the termination region **1004'** in place of the guard ring edge termination included in power MOSFET **1000.** As known to those of skill in the art, a junction termination extension may be formed as a series of rings (e.g., square or rectangular rings having rounded corners when viewed from above) of first conductivity type material (here p-type) that are formed in the upper surface of a second conductivity type (here n-type) semiconductor layer structure in the termination region a device. The rings may have a decreasing concentration of the first conductivity type dopants with increasing distance from the active region. In the depicted embodiment, the junction termination extension comprises a total of three p-type implanted rings **1052, 1054, 1056** in the upper surface of the semiconductor layer structure **1006,** with the inner ring **1052** having the highest concentration of p-type dopants and the outer ring **1056** having the lowest concentration of p-type dopants. More or fewer rings may be provided. As the MOSFET **1000'** may otherwise be identical to the power MOSFET **1000,** further description thereof will be omitted.

**FIG. 15** is a horizontal cross-section of a power MOSFET **1100** according to further embodiments of the present invention. The power MOSFET **1100** may have the general design of power MOSFET **700** of **FIGS. 7A-7B** above, and hence has guard rings **1150** that are formed below and in the sidewalls of termination trenches **1180.** The horizontal cross-section of **FIG. 15** is taken through the portions of the guard rings **1150** that are below the termination trenches **1180.** The power MOSFET **1100** is formed using a single angled ion implant to form the deep shielding patterns (not shown) and guard rings **1150** thereof.

**FIG. 15** illustrates how the widths of the guard rings **1150** may be varied to take into account the asymmetries associated with an angled ion implant. In particular, because an angled ion implant is used to implant the bottom surfaces of the termination trenches **780,** the width of the portions of the guard rings **1150** that are perpendicular to the direction in which the ion implant is tilted may be decreased slightly. As shown in **FIG. 15****,** the portions of the termination trenches **1180** that are above and below the active region in the view of **FIG. 15** have a width W3, and the gaps between adjacent trenches **1180** in these portions of the termination region **1104** have a width W4. In order to accommodate for the slight decrease in the width of the portions of the guard rings **1150** that are perpendicular to the direction in which the ion implant is tilted, the portions of the termination trenches **1180** that are on the left and right sides of the active region **1102** are etched to have a slightly larger width W2 (W2 = W3 + δ, where δ is a positive number), and the gaps between adjacent termination trenches **1180** on the left and right sides of the active region **1102** have a slightly smaller width W1 = W4 - δ. This approach may be used to provide an equal distance between adjacent guard rings **1150** all the way around the termination region **1104.**

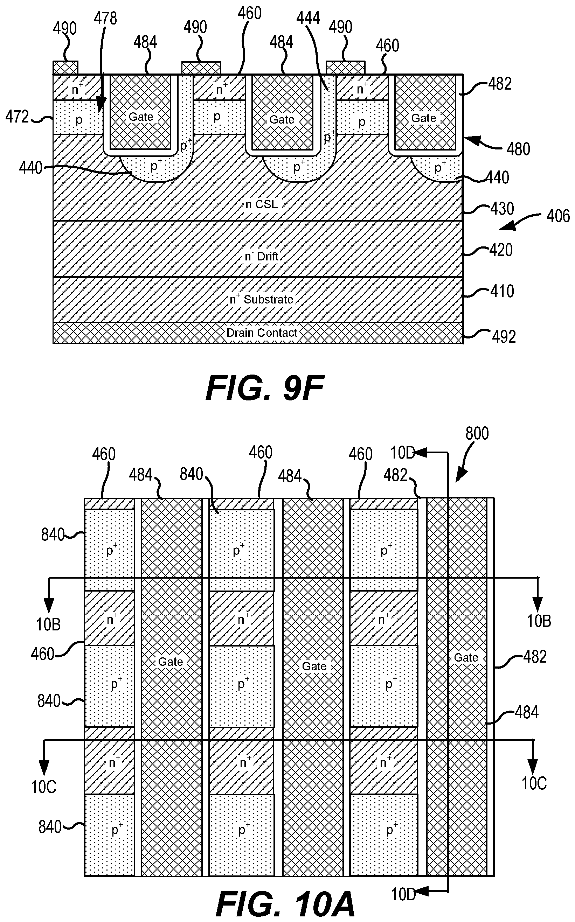

If a pair of angled ion implants are performed (with the angled implants being tilted in opposite directions) instead of a single angled ion implant, as is discussed below with reference to the embodiment of **FIGS. 10A-10C****,** then the effect of the double angled implant is to slightly increase the width of the portions of the guard rings **1150** that are perpendicular to the directions in which the ion implants are tilted. Consequently, when a double angled implant is used, the termination trenches **1180** may be formed to have the widths W2 and W3 shown in **FIG. 15** except that δ is a negative number.

The power semiconductor devices **400, 500, 600** and **700** described above with reference to **FIGS. 4A-7B** each have deep shielding patterns and associated deep shielding connection patterns that extend linearly throughout the device. This can be seen, for example, in **FIG. 4A** where the deep shielding connection patterns **444** each extend linearly across the active region **402** alongside the gate trenches **480.** It will be appreciated, however, that in other embodiments each of the power semiconductor devices **400, 500, 600** and **700** may be modified to have deep shielding patterns and associated deep shielding connection patterns that are segmented.

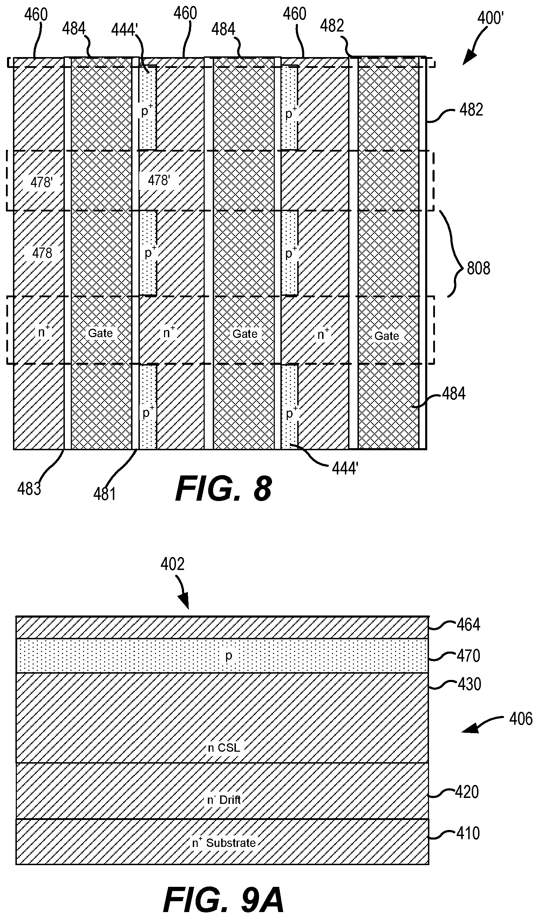

As an example, **FIG. 8** is a plan view of a power MOSFET **400'** that is a is a modified version of the power MOSFET **400** of **FIGS. 4A-4B****.** The one difference between power MOSFET **400** and power MOSFET **400'** is that an additional mask pattern is used during the ion implantation step that is used to form the deep shielding patterns and the deep shielding connection patterns. The additional mask pattern that is added is shown in dotted lines as additional masking **808** in **FIG. 8****.** As is readily apparent, the inclusion of the additional mask material breaks the deep shielding patterns and the deep shielding connection patterns into segments that are labeled deep shielding patterns **440'** and deep shielding connection patterns **444'** in **FIG. 8****.** When this design is used, portions of the p-wells **472** on the sides of each deep shielding pattern **440'** may be used as additional conducting channel regions **478',** which may help lower the overall on-state resistance of the device. In other words, in the MOSFET **400'** of **FIG. 8****,** channels **478** are formed along the second sidewalls **483** of the gate trenches **480** just like in the MOSFET **400,** and additional channel regions **478'** are formed along both sidewalls **481, 483** of the gate trenches **480** in the regions between the deep shielding patterns **440'** and the deep shielding connection patterns **444'.** The channels **478, 478'** would be directly below the reference numerals **478, 478'** in **FIG. 8****.** The exact same modification may also be made to the power semiconductor devices **500, 600** and **700** that are described above.

**FIGS. 9A-9F** are schematic cross-sectional diagrams that illustrate a method of fabricating the gate trench power MOSFET **400** of **FIGS. 4A-4B****.** Referring first to **FIG. 9A****,** a heavily-doped (n⁺) n-type silicon carbide substrate **410** is provided that includes an active region **402** (only the active region **402** is shown). A lightly-doped (n⁻) silicon carbide drift region **420** is formed on the substrate **410** via epitaxial growth. An n-type silicon carbide current spreading layer **430** is formed that comprises the upper portion of the n⁻ silicon carbide drift layer **420.** A moderately-doped p-type layer **470** is formed on the upper surface of the n-type silicon carbide current spreading layer **430.** A silicon carbide layer **464** is formed on top of the moderately-doped p-type layer **470.** The silicon carbide layer **464** may be an undoped layer in some embodiments. The layers **410, 420, 430, 470, 464** may all be grown in a single epitaxial growth process with process stops to switch between n-type doping and p-type doping to form a semiconductor layer structure **406.**

Referring to **FIG. 9B****,** gate trenches **480** may be etched into the upper surface of the semiconductor layer structure **406.** The gate trenches **480** may each extend in a first direction and may be spaced apart from each other in a second direction. The gate trenches **480** may extend in parallel to each other. Each gate trench **480** may extend through the heavily-doped n-type silicon carbide layer **464** in order to convert the silicon carbide layer **464** into a plurality of spaced apart regions **464'** that will ultimately serve as the source regions **460** of the power MOSFET **400.** Each gate trench **480** may also extend through the moderately-doped p-type silicon carbide layer **470** in order to convert layer **470** into a plurality of p-wells **472.** Each gate trench **480** may also extend into an upper surface of the n-type current spreading layer **430.** The gate trenches **480** may have U-shaped cross-sections in some embodiments.

Referring to **FIG. 9C****,** an angled ion implantation step may be performed to form a plurality of spaced apart heavily-doped p-type silicon carbide deep shielding patterns **440** underneath the respective gate trenches **480** and to form heavily-doped p-type deep shielding connection patterns **444** in first sidewalls of the gate trenches **480.** The deep shielding connection patterns **444** electrically connect the p-type silicon carbide deep shielding patterns **440** to (among other things) the p-wells **472.** The heavily-doped p-type deep shielding connection patterns **444** may extend to the upper surface of the device.

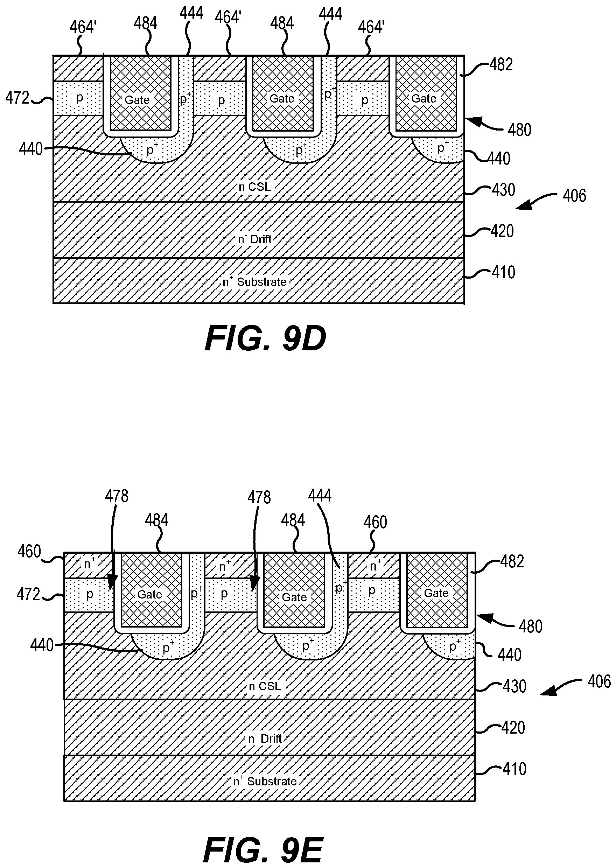

Next, referring to **FIG. 9D****,** a gate insulating layer **482** such as a silicon oxide layer is formed on the bottom surface and sidewalls of each gate trench **480.** A gate electrode **484** is formed on each gate insulating layer **482.** Each gate electrode **484** may fill the remainder of its respective gate trench **480.**

Next, referring to **FIG. 9E****,** another ion implantation step is performed to convert the undoped regions **464'** into heavily doped (n⁺) n-type silicon carbide source regions **460.** Vertical channel regions **478** are provided in the p-wells **472** adjacent one side of each gate trench **480** (the left side in **FIG. 9E**). The channel regions **478** extend between the heavily doped (n⁺) n-type silicon carbide source regions **460** and the n-type silicon carbide current spreading layer **430.**

Referring to **FIG. 9F****,** source contacts **490** are formed on the heavily-doped n-type source region **460** and on the heavily-doped p-type deep shielding connection patterns **444.** A drain contact **492** is formed on the lower surface of the substrate **410** to complete the device.

While the fabrication steps are set forth in one example order in the discussion above, it will be appreciated that the fabrication steps may be performed in a different order. For example, the order of the various etching and ion implantation steps may be changed from what is described above.

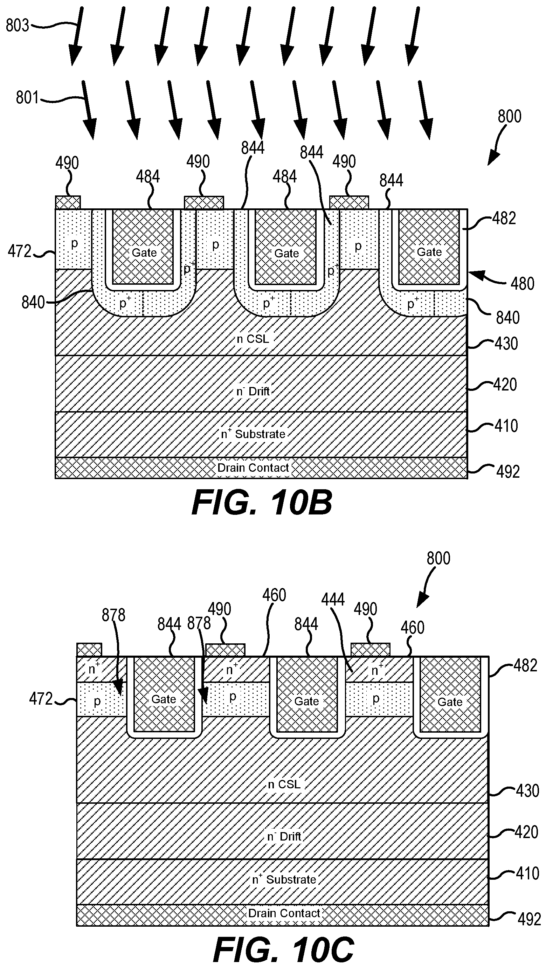

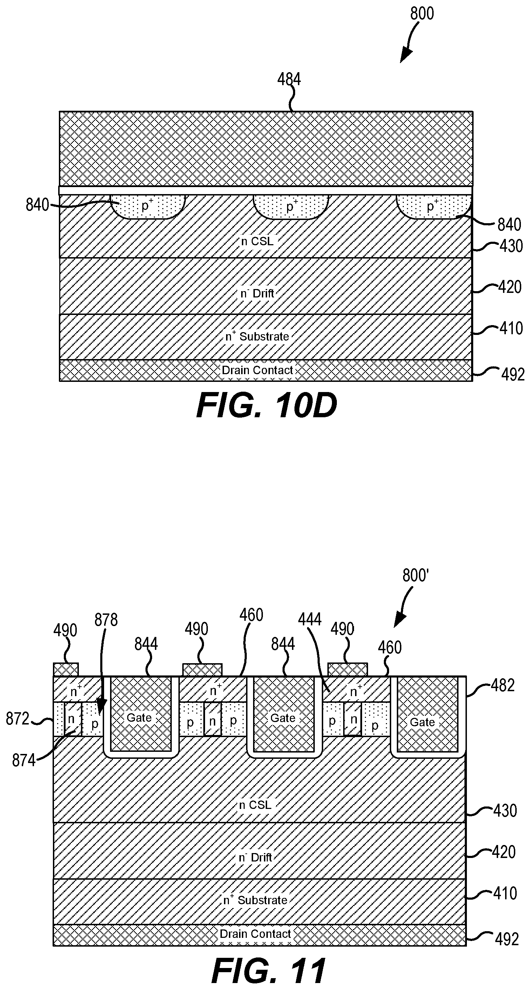

**FIGS. 10A-10D** illustrate a power MOSFET **800** according to further embodiments of the present invention. In particular, **FIG. 10A** is a schematic plan view of a portion of the power MOSFET **800,** and **FIGS. 10B, 10C** and **10D** are a schematic cross-sectional views of the power MOSFET **800** taken along lines **10B-10B, 10C-10C** and **10D-10D** of **FIG. 10A****,** respectively.

Referring to **FIGS. 10A-10D****,** the power MOSFET **800** is similar to the power MOSFET **400'** of **FIG. 8****.** In particular, the power MOSFET **800** includes deep shielding patterns **840** that are formed in horizontal stripes across the device (when the device is oriented as shown in **FIG. 10A**). During the ion implantation step used to form the deep shielding patterns **840,** a mask comprising horizontal stripes is placed over the active region so that the deep shielding patterns **440** and deep shielding connection patterns **444** that extend underneath/alongside each gate trench **480** in MOSFET **400** are instead segmented so that a plurality of deep shielding regions **840** and deep shielding connection patterns **844** are provided underneath/alongside each gate trench **480.** Moreover, a pair of angled ion implants are performed so that deep shielding connection patterns **844** are formed in both sidewalls of each gate trench **480.** The channels of the MOSFET **800** are formed underneath these masked regions (i.e., in the regions between deep shielding patterns **840** and deep shielding connection patterns **844** that are adjacent each other along the direction of the gate trenches **480**), as will be discussed in more detail below with reference to **FIGS. 10C** and **10D****.**

As noted above, one of the primary differences between the power MOSFET **800** and the power MOSFET **400'** is that a pair of angled implants are performed during the fabrication of power MOSFET **800.** This is shown schematically in **FIG. 10B****,** where the arrows labelled **801** represent a first implant that is used to form first portions of the deep shielding patterns **840** and the deep shielding connection patterns **844** (herein, the "first deep implant") and the arrows labelled **803** represent the second implant that is used to form second portions of the deep shielding patterns **840** and the deep shielding connection patterns **844** (herein, the "second deep implant"). The first deep implant may be used to implant p-type dopants into the portion of the current spreading layer **430** under the right side of each gate trench **480** and into the right sidewall of each gate trench **480,** while the second deep implant may be used to implant p-type dopants into the portion of the current spreading layer **430** under the left side of each gate trench **480** and into the right sidewall of each gate trench **480.** The vertical dotted lines included in each deep shielding pattern **840** are used to approximately divide the respective portions of the deep shielding patterns **840** that are formed by the respective first and second deep implants.

As noted above, the deep shielding patterns **840** are segmented into spaced-apart regions instead of extending continuously along the gate trenches **480** as is the case in the embodiment of **FIGS. 4A-4B****.** Channel regions **878** are formed in the device between the deep shielding patterns **840,** as can be seen in the cross-section of **FIG. 10C****.** The channels **878** are formed on both sides of the gate trenches **480,** as shown. While the deep shielding patterns **840** do not extend under the gate trenches **480** in the regions of the device where the channels **878** are formed, the provision of the deep shielding patterns **840** under other portions of the gate trenches **480** may protect the gate insulating layer **482** from excessive electric fields during reverse blocking operation. It should be noted that while the first and second implants are angled in a first direction that extends perpendicular to the gate trenches **480** (see **FIG. 10B**) in order to implant the first and second sidewalls of the gate trenches **480,** the implant is not angled in a perpendicular direction that extends parallel to the gate trenches **480.**

One advantage of the power MOSFET **800** is that the deep shielding patterns **840** may readily be formed to a desired depth since the implant is made into the bottom surfaces of the gate trenches **480,** while also providing a good electrical connection between the deep shielding patterns **840** and the p-wells **472** by implanting the sidewalls of selected portions of the gate trenches **480** to form the deep shielding connection patterns **844.** This approach allows the deep shielding patterns **840** to be spaced closer together as compared to the power MOSFET **200** of **FIG. 2** above, which is advantageous for control of the blocking properties and the on-state resistance of the device. Additionally, since the angled implant provides the electrical connection between the deep shielding patterns **840** and the p-wells **472,** the need for separate electrical connections may be eliminated, which is one of the disadvantages of the power MOSFET **300** of **FIG. 3** above. Moreover, fabrication of the power MOSFET **800** does not require the second epitaxial growth step that is used in the fabrication of the power MOSFET of **FIG. 1** which can lead to alignment difficulties and requires an extra fabrication step.

**FIG. 11** is a cross-sectional view taken along line **10C-10C** of **FIG. 10A** that illustrates the design of a modified version **800'** of the power MOSFET **800 of** **FIGS. 10A-10D****.** As shown in **FIG. 11**, the one difference between the power MOSFET **800'** and the power MOSFET **800** is that the p-wells **872** in the power MOSFET **800'** further include thin stripes (e.g., less than 0.5 microns wide) of un-implanted n-type silicon carbide **874.** The stripes **874** of n-type silicon carbide included in the p-wells **872** may have a doping concentration of, for example, less than 1x10¹⁷/cm³ in some embodiments. The rest of the p-wells **872** may be more highly-doped p-type, at least with a doping concentration greater than 1x10¹⁷/cm³. The provision of the n-type silicon carbide stripes **874** may enhance the current flow through the channel regions, and since they have low doping concentrations the n-type silicon carbide stripes **874** may be depleted during normal off-state operation.

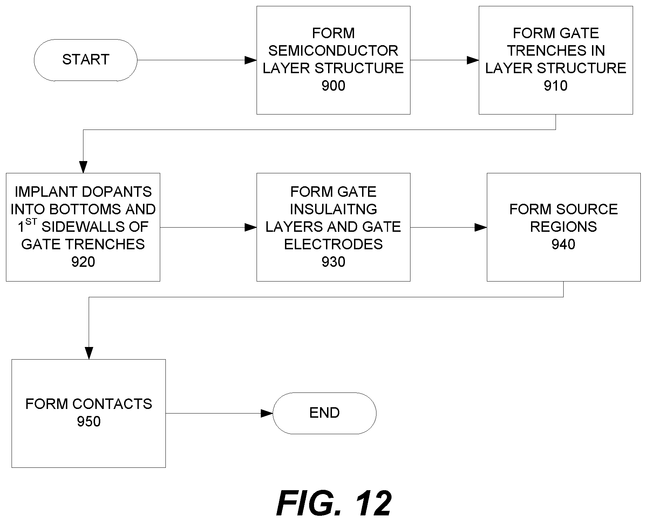

**FIG. 12** is a flow chart that illustrates a method of fabricating a gate trench power semiconductor device having a buried edge termination according to embodiments of the present invention.

With reference to **FIG. 12** and **FIGS. 9A****-9F,** operations may begin with a wide band-gap semiconductor layer structure (Block **900**). The semiconductor layer structure may include a substrate and a plurality of semiconductor layers that are grown on the substrate by epitaxial growth. The semiconductor layer structure may include a drift region that has a first conductivity type. The semiconductor layer structure may further include well regions having a second conductivity type on the drift region. A plurality of gate trenches are formed in an upper surface of the semiconductor layer structure (Block **910**). The gate trenches may extend in a first direction and may be spaced apart from each other in a second direction that is perpendicular to the first direction. Each gate trench may have a bottom surface, a first sidewall that extends in the first direction and a second sidewall that extends in the first direction. Dopants having the second conductivity type that is opposite the first conductivity type may be implanted into the bottom surfaces and the first sidewalls of the respective gate trenches (Block **920**). In some embodiments, the dopants having the second conductivity type may be implanted into the first sidewalls of the gate trenches using an angled ion implant. The angled ion implant may be at an implant angle of, for example, between 2 and 15 degrees in some embodiments. The second conductivity dopants implanted into the bottom surfaces of the gate trenches may form a plurality of deep shielding patterns underneath the respective gate trenches, and the second conductivity dopants implanted into the first sidewall of the gate trenches may form a plurality of deep shielding connection patterns that electrically connect the deep shielding regions to the respective well regions. Gate insulating layers and gate electrodes may be formed in the gate trenches (Block **930**). Source regions having the first conductivity type may be formed on the well regions via ion implantation (Block **940**). Contacts may be formed on the top and bottom surfaces of the semiconductor layer structure to complete the device (Block **950**).

The completed device may include channel regions that are formed in the respective second sidewalls of the gate trenches. In some embodiments, each channel region may be directly opposite a portion of a respective one of the deep shielding connection patterns that are formed in the first sidewalls of the gate trenches.

In the description above, each example embodiment has a certain conductivity type. It will be appreciated that opposite conductivity type devices may be formed by simply reversing the conductivity of the n-type and p-type layers in each of the above embodiments. Thus, it will be appreciated that the present invention covers both n-channel and p-channel devices for each different device structure (e.g., MOSFET, IGBT, etc.). Herein, where a contact can be either a source contact or a drain contact it may be referred to as a "source/drain contact."

While the present invention is described above with respect to power MOSFET and power IGBT implementations, it will be appreciated that the techniques described herein apply equally well to other similar vertical power devices having a gate trench. Thus, embodiments of the present invention are not limited MOSFETs and IGBTs, and the techniques disclosed herein may be used on any appropriate gate trench device.

The present invention has primarily been discussed above with respect to silicon carbide based power semiconductor devices. It will be appreciated, however, that silicon carbide is used herein as an example and that the devices discussed herein may be formed in any appropriate wide band-gap semiconductor material system. As an example, gallium nitride based semiconductor materials (e.g., gallium nitride, aluminum gallium nitride, etc.) may be used instead of silicon carbide in any of the embodiments described above.

It will also be appreciated that the different features of the different embodiments described herein may be combined to provide additional embodiments. For example, it was discussed above with respect to one embodiment that junction termination extensions could be used in place of guard rings. This is true in each embodiment disclosed herein. Likewise, the shield regions under the gate trenches may be included or omitted in any of the embodiments. Any of the embodiments may also include well regions that have varying dopant concentrations including lower doped channel regions.

Embodiments of the present invention have been described above with reference to the accompanying drawings, in which embodiments of the invention are shown. It will be appreciated, however, that this invention may, however, be embodied in many different forms and should not be construed as limited to the embodiments set forth above. Rather, these embodiments are provided so that this disclosure will be thorough and complete, and will fully convey the scope of the invention to those skilled in the art. Like numbers refer to like elements throughout.

It will be understood that, although the terms first, second, etc. are used throughout this specification to describe various elements, these elements should not be limited by these terms. These terms are only used to distinguish one element from another. For example, a first element could be termed a second element, and, similarly, a second element could be termed a first element, without departing from the scope of the present invention. The term "and/or" includes any and all combinations of one or more of the associated listed items.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" "comprising," "includes" and/or "including" when used herein, specify the presence of stated features, integers, steps, operations, elements, and/or components, but do not preclude the presence or addition of one or more other features, integers, steps, operations, elements, components, and/or groups thereof.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "top" or "bottom" may be used herein to describe a relationship of one element, layer or region to another element, layer or region as illustrated in the figures. It will be understood that these terms are intended to encompass different orientations of the device in addition to the orientation depicted in the figures.

Embodiments of the invention are described herein with reference to cross-section illustrations that are schematic illustrations of idealized embodiments (and intermediate structures) of the invention. The thickness of layers and regions in the drawings may be exaggerated for clarity. Additionally, variations from the shapes of the illustrations as a result, for example, of manufacturing techniques and/or tolerances, are to be expected. Embodiments of the invention are also described with reference to a flow chart. It will be appreciated that the steps shown in the flow chart need not be performed in the order shown.

Some embodiments of the invention are described with reference to semiconductor layers and/or regions which are characterized as having a conductivity type such as n-type or p-type, which refers to the majority carrier concentration in the layer and/or region. Thus, n-type material has a majority equilibrium concentration of negatively charged electrons, while p-type material has a majority equilibrium concentration of positively charged holes. Some material may be designated with a "+" or "-" (as in n+, n-, p+, p-, n++, n--, p++, p--, or the like), to indicate a relatively larger ("+") or smaller ("-") concentration of majority carriers compared to another layer or region. However, such notation does not imply the existence of a particular concentration of majority or minority carriers in a layer or region.

In the drawings and specification, there have been disclosed typical embodiments of the invention and, although specific terms are employed, they are used in a generic and descriptive sense only and not for purposes of limitation, the scope of the invention being set forth in the following claims.

## Claims

1. A semiconductor device, comprising:
a semiconductor layer structure (406) comprising a drift region that includes a wide band-gap semiconductor material, the drift region having a first conductivity type;
a gate trench (480) in an upper portion of the semiconductor layer structure, the gate trench having first (481) and second (483) opposed vertical sidewalls that extend in a first direction in the upper portion of the semiconductor layer structure;
a deep shielding pattern (440) having a second conductivity type that is opposite the first conductivity type in the semiconductor layer structure underneath a bottom surface of the gate trench;
a deep shielding connection pattern (444) that has the second conductivity type along the first vertical sidewall of the gate trench; and
a semiconductor channel region (478) that has the second first conductivity type along the second vertical sidewall of the gate trench,
wherein the semiconductor layer structure further comprises a well region (472) having the second conductivity type, wherein the deep shielding connection pattern electrically connects the deep shielding pattern to the well region, and
wherein the gate trench has rounded bottom corners.

2. The semiconductor device of Claim 1, wherein the deep shielding pattern (440) extends underneath most of the gate trench (480).

3. The semiconductor device of Claim 2, wherein the deep shielding pattern extends underneath most, but less than all, of the bottom surface of the gate trench.

4. The semiconductor device of any of Claims 1-3, wherein the deep shielding connection pattern (444) extends from the deep shielding pattern (440), through the well region (472) to a top surface of the semiconductor layer structure (406).

5. The semiconductor device of any of Claims 1-4, wherein a doping concentration of the deep shielding connection pattern (444) is greater than a doping concentration of the well region (472).

6. The semiconductor device of Claim 5, wherein doping concentrations of the deep shielding connection pattern (444) and the deep shielding pattern (440) are greater than a doping concentration of the well region (472).

7. The semiconductor device of any of Claims 1-6, wherein the semiconductor layer structure (406) further comprises a current spreading layer (430) having the first conductivity type between the drift region (420) and the well region (472), wherein a first conductivity doping concentration of the current spreading layer is higher than a first conductivity type doping concentration of the drift region.

8. The semiconductor device of Claim 1, wherein the deep shielding pattern (440) comprises a plurality of spaced apart deep shielding regions underneath the gate trench (480) and the deep shielding connection pattern (444) comprises a plurality of spaced apart deep shielding connection regions in the first sidewall (481) of the gate trench, wherein the semiconductor channel region (478) is along a portion of the second sidewall (483) that is opposite a portion of the first sidewall that is between first and second of the deep shielding connection regions.

9. The semiconductor device of Claim 1, further comprising a second semiconductor channel region (478') that has the second conductivity type in the first vertical sidewall (481) of the gate trench (480).

10. The semiconductor device of Claim 1, wherein the deep shielding pattern (440) and the deep shielding connection pattern (444) are formed via angled ion implantation.
